# EUROPÄISCHE PATENTSCHRIFT

(11) **EP 3 338 325 B1**
(45) Veröffentlichungstag und Bekanntmachung des Hinweises auf die Patenterteilung: **22.08.2018**
(21) Anmeldenummer: 17787364.3
(22) Anmeldetag: 09.10.2017
(51) Int. Cl.: H01R 13/24, G01R 1/067, G01R 1/073

(54) **KONTAKTSYSTEM UND KONTAKTMODUL**
CONTACT SYSTEM AND CONTACT MODULE
SYSTÈME DE CONTACT ET MODULE DE CONTACT

(30) Priorität: 10.11.2016 DE 102016013412
(43) Veröffentlichungstag der Anmeldung: 27.06.2018
(73) Patentinhaber: Rosenberger Hochfrequenztechnik GmbH & Co. KG, 83413 Fridolfing (DE)
(72) Erfinder: TATZEL, Frank, 5121 Ostermiething (AT)
(86) Internationale Anmeldenummer: PCT/EP2017/075670
(87) Internationale Veröffentlichungsnummer: WO 2018/086809

(56) Entgegenhaltungen:
- DE-A1- 2 905 175
- GB-A- 1 316 108
- US-A- 5 762 504
- US-A1- 2010 182 029

## Beschreibung

### GEBIET DER ERFINDUNG

Die vorliegende Erfindung betrifft ein Kontaktsystem aus mindestens einem Kontaktstift, mit dem ein einzelner Kontaktpunkt oder ein Raster von Kontaktpunkten kontaktiert werden kann, um jeweils mindestens ein elektrisches Signal zu erfassen und zu übertragen. Daneben betrifft die vorliegende Erfindung auch ein einzelnes Kontaktmodul mit einem Kontaktstift.

### TECHNISCHER HINTERGRUND

Aus dem Stand der Technik ist eine Vielzahl von Kontaktsystemen bekannt. Die Kontaktsysteme können nach dem Aufbau ihrer Kontaktstifte im Wesentlichen in drei Gruppen aufgeteilt werden:
- Kontaktsysteme mit Federkontaktstiften, wie sie beispielsweise in der US 6,624,645 B2 offenbart sind,
- Kontaktsysteme mit Hebelarmen, wie sie beispielsweise in der US 7,555,834 B2 beschrieben sind und
- Kontaktsysteme mit Knickstäben, wie sie beispielsweise aus der US 5,324,205 A1 hervorgehen.

Eine spezielle Ausführung eines Kontaktsystems mit Federkontaktstiften geht jeweils aus der US 2010/0182029 A1 und aus der US 5,762,504 A hervor. In diesen Kontaktsystemen sind in gegenüberliegenden Wänden einer Druckkammer jeweils Kontaktstifte beweglich angeordnet, die über eine Feder miteinander verbunden sind und auf diese Weise eine Elastizität aufweisen. Zur Kontaktierung der einzelnen Kontaktstifte mit zugehörigen Kontaktflächen werden die einzelnen Kontaktstifte in der Druckkammer mit einem bestimmten Druck beaufschlagt.

Die vom Kontaktsystem zu kontaktierenden Kontaktpunkte können hierbei in verschiedenen genormten Konfigurationen am Gehäuse einer integrierten Schaltung, wie beispielsweise Ball-Grid-Array (BGA) (deutsch: Kugel-Gitter-Feld) oder Quad-Flat-No-Leads-Package (QFN) (deutsch: quadratische, flache Verpackung ohne Leitungen), angeordnet sein.

Allen diesen Kontaktstiften ist gemeinsam, dass die zur Kontaktierung erforderliche Feder- oder Vorspannkraft durch elastische Verformung eines Bauteils (Spiralfeder beim Federkontaktstift) oder des gesamten Kontaktstiftes (Hebelarm oder Knickstab) hergestellt wird. Um die Anforderungen an die Kontaktkraft, den Federweg und die Standfestigkeit in einer bestimmten Anwendung des elastischen Kontaktstiftes zu erreichen, ergibt sich unter Beachtung der strukturmechanischen Gesetzmäßigkeiten unter Umständen eine relativ große Baugröße für den elastischen Kontaktstift.

Dies zieht mehrere Nachteile mit sich:
Die für die reflexionsminimierte Übertragung von Hochfrequenzsignalen erforderliche elektrische Anpassung des Kontaktstiftes an das gesamte Messsystem, die typischerweise schon schwierig zu bewerkstelligen ist, wird durch die Verlängerung des Kontaktstiftes noch zusätzlich erschwert. Dies wirkt sich nachteilig auf die Signalintegrität des zu übertragenden Hochfrequenzsignals aus.

Außerdem ergibt sich für jeden Punkt des Federweges eine andere Kontaktkraft. Diese Nichtlinearität des elastischen Kontaktstiftes wirkt sich besonders nachteilig aus, wenn axiale Toleranzen, beispielsweise bei Schiefstellung, bei Verschleiß oder Planaritätstoleranzen des Kontaktflächenrasters, ausgeglichen werden müssen.

Alterungsbedingte Schwankungen der Federkraft aufgrund beispielsweise der Relaxation des elastischen Kontaktstiftes können gar nicht oder nur unter großem Aufwand ausgeglichen werden.

Soll die Kontaktkraft des elastischen Kontaktstiftes beispielsweise bei empfindlichen Kontaktpunkten, bei Hochstromanwendungen oder bei oxidierten Kontaktpunkten angepasst werden, so ist dies ebenfalls nicht oder nur schwer möglich.

Halbleiterbauelemente werden oft unter extremen Temperaturverhältnissen, beispielsweise in Burn-in-Tests, getestet. In diesen Fällen werden die elastischen Kontaktstifte oft sehr hohen oder sehr niedrigen Temperaturen ausgesetzt, so dass sie als Wärmeleiter fungieren und Wärme unerwünscht vom Messobjekt ableiten oder dem Messobjekt zuführen.

Dies ist ein Zustand, den es zu verbessern gilt.

### ZUSAMMENFASSUNG DER ERFINDUNG

Vor diesem Hintergrund liegt der vorliegenden Erfindung die Aufgabe zugrunde, ein einen Kontaktstift enthaltendes Kontaktmodul und ein Kontaktsystem, das mindestens einen Kontaktstift enthält, anzugeben, die jeweils die oben genannten Nachteile überwinden.

Erfindungsgemäß wird diese Aufgabe durch ein Kontaktsystem mit den Merkmalen des Patentanspruchs 1 und durch ein Kontaktmodul mit den Merkmalen des Patentanspruchs 14 gelöst. Vorteilhafte technische Erweiterungen sind in den jeweils abhängigen Patentansprüchen aufgeführt.

Das erfindungsgemäße Kontaktsystem enthält hierzu mindestens einen pneumatisch angesteuerten Kontaktstift, eine Druckkammer und einen im Gehäuse der Druckkammer für jeden Kontaktstift jeweils vorgesehene erste Durchführung.

Unter Durchführung wird hierbei und im Folgenden eine Öffnung zwischen der Druckkammer und dem Außenraum der Druckkammer innerhalb des Gehäuses der Druckkammer verstanden. Die Durchführung weist hierbei im Wesentlichen eine bestimmte Längserstreckung und ein bestimmtes Querschnittsprofil bzw. einen Verlauf des Querschnittprofils entlang der Längserstreckung auf. Optional kann die Durchführung auch in Ergänzung zur Längserstreckung eine sich an die Längserstreckung anschließende Quererstreckung und/oder eine sich an die Längs- bzw. Quererstreckung anschließende und in einem beliebigen Winkel zur Längserstreckung orientierte zusätzliche Erstreckung aufweisen.

Die einzelne erste Durchführung weist einen der Druckkammer abgewandten ersten Abschnitt mit einem ersten Innendurchmesser und einen der Druckkammer zugewandten zweiten Abschnitt mit einem gegenüber dem ersten Innendurchmesser größeren zweiten Innendurchmesser.

Der erste Abschnitt des Kontaktstiftes weist einen ersten Außendurchmesser auf, während der zweite Abschnitt des Kontaktstiftes einen gegenüber dem ersten Außendurchmesser größeren zweiten Außendurchmesser besitzt, der dem Innendurchmesser des zweiten Abschnittes der ersten Durchführung entspricht.

Der zweite Abschnitt des Kontaktstiftes ist im zweiten Abschnitt der ersten Durchführung axial bewegbar geführt und zur Kontaktierung ist der erste Abschnitt des Kontaktstiftes im ersten Abschnitt der ersten Durchführung durchgeführt.

Die axiale Position jedes Kontaktstiftes in der zugehörigen ersten Durchführung korrespondiert zu einem Druckniveau eines Druckmediums in der Druckkammer.

Dadurch, dass sich der Außendurchmesser des Kontaktstiftes als auch der Innendurchmesser der ersten Durchführung vom ersten Abschnitt des Kontaktstiftes bzw. vom ersten Abschnitt der ersten Durchführung zum zweiten Abschnitt des Kontaktstiftes bzw. zum zweiten Abschnitt des Kontaktstiftes der ersten Durchführung vergrößert, bildet sich bei einer bestimmten axialen Position des Kontaktstiftes innerhalb der ersten Durchführung ein bestimmter Hohlraum zwischen der Innenwandung des zweiten Abschnitts der ersten Durchführung, der Zylinderaußenmantelfläche des ersten Abschnitts des Kontaktstiftes, der druckkammerabgewandten Stirnfläche des zweiten Abschnitts des Kontaktstiftes und der druckkammerzugewandten Stirnfläche des ersten Abschnittes der ersten Durchführung aus. In diesem Hohlraum befindet sich Luft mit einer bestimmten Kompressibilität, die bei der axialen Bewegung des Kontaktstiftes in Richtung des Außenraumes der Druckkammer eine dämpfende Wirkung auf den sich axial bewegenden Kontaktstift ausübt. Auf diese Weise lässt sich ein elastischer Kontaktstift vorteilhaft durch einen starren Kontaktstift ersetzen. Auch die bei einem pneumatisch angesteuerten Kontaktstift üblicherweise verwendete Spiralfeder zur Aufbringung einer Dämpfung des Kontaktstiftes kann vorteilhaft vermieden werden.

Zur gezielten Temperierung des Kontaktstiftes, um einen Wärmezufluss oder -abfluss vom temperierten Gehäuse der zu prüfenden integrierten Schaltung über den Kontaktstift zu verhindern, wird erfindungsgemäß das Druckmedium in der Druckkammer temperaturgeregelt. Der Kontaktstift, der mit dem Druckmedium der Druckkammer in Verbindung steht, nimmt somit mittels Wärmeübergang oder Wärmekonvektion die Temperatur des Druckmediums an. Bei einer Angleichung der Temperatur des Druckmediums an die Temperatur des Gehäuses wird damit eine Wärmezu- oder -abfuhr über den Kontaktstift verhindert.

Um die Temperierung des Kontaktstiftes mittels Wärmeübergang nicht nur in dem Bereich, in dem der Kontaktstift innerhalb der Druckkammer mit dem Druckmedium direkt in Verbindung steht, zu realisieren, sondern auch über eine größere Längserstreckung des Kontaktstiftes, ist in einer bevorzugten Erweiterung der Erfindung mindestens ein Luftkanal innerhalb des Kontaktstiftes vorgesehen, der sich von dem der Druckkammer zugewandten Ende des Kontaktstiftes über eine bestimmte Längserstreckung im zweiten Abschnitt des Kontaktstiftes erstreckt. Jeder dieser Luftkanäle wird im Folgenden als erster Luftkanal bezeichnet.

Diese ersten Luftkanäle füllen sich mit dem temperierten Druckmedium und realisieren bevorzugt eine gleichmäßigere und schnellere Temperierung des Kontaktstiftes entlang der Längserstreckung des mindestens einen ersten Luftkanals.

Unter einem Luftkanal wird hierbei und im Folgenden ein Hohlraum mit einem bestimmten Querprofil und einem bestimmten Verlauf innerhalb eines mechanischen Bauteils und/oder zwischen mindestens zwei aneinander angrenzenden mechanischen Bauteilen verstanden.

Zusätzlich sind Luftkanäle zwischen dem Innenraum des zweiten Abschnitts der ersten Durchführung und dem Außenraum der Druckkammer vorgesehen, die im Folgenden als zweite Luftkanäle bezeichnet werden.

Die axiale Position der einzelnen zweiten Luftkanäle im zweiten Abschnitt der ersten Durchführung und die Längserstreckung der ersten Luftkanäle im zugehörigen Kontaktstift sind so ausgelegt, dass bei einer axialen Position des Kontaktstiftes innerhalb eines bestimmten Positionsbereiches in der ersten Durchführung eine Verbindung zwischen jedem zweiten Luftkanal und mindestens einem ersten Luftkanal besteht. Die axiale Position eines Kontaktstiftes innerhalb eines bestimmten Positionsbereiches resultiert aus unterschiedlichen Abständen des zu kontaktierenden Kontaktpunktes auf dem Gehäuse der zu prüfenden integrierten Schaltung zum Kontaktsystem.

Auf diese Weise ist über die ersten und zweiten Luftkanäle jeweils ein Luftaustausch zwischen der Druckkammer und dem Außenraum der Druckkammer realisiert, der über Wärmekonvektion den Kontaktstift beschleunigt auf das Temperaturniveau des Druckmediums in der Druckkammer temperiert.

In einer ersten Ausführungsform der Erfindung ist jeder erste Luftkanal bevorzugt jeweils als Ausnehmung realisiert, die in Längsrichtung an der Zylinderaußenmantelfläche des zweiten Abschnitts des Kontaktstiftes verläuft. Jede dieser Ausnehmungen erstreckt sich vom Ende des Kontaktstiftes, der der Druckkammer zugewandt ist, über eine bestimmte Längserstreckung im zweiten Abschnitt des Kontaktstiftes.

In einer bevorzugten Erweiterung der ersten Ausführungsform der Erfindung weist jede Ausnehmung an ihrem der Druckammer abgewandten Ende jeweils einen konischen oder kegelstumpfförmigen Verlauf auf. Auf diese Weise wird durch das in jedem ersten Luftkanal jeweils strömende gleich große Luftvolumen der Kontaktstift in der ersten Durchführung zentriert.

In einer zweiten Ausführungsform der Erfindung ist jeder erste Luftkanal jeweils als eine für jeden ersten Luftkanal gemeinsame erste Bohrung in Längsrichtung des zweiten Abschnitts des Kontaktstiftes innerhalb des Kontaktstiftes und einer sich daran anschließenden, in Querrichtung zum zweiten Abschnitt des Kontaktstiftes verlaufende zweite Bohrung realisiert. Die erste Bohrung erstreckt sich ebenfalls vom Ende des Kontaktstiftes, das der Druckkammer zugewandt ist, über eine bestimmte Längserstreckung im zweiten Abschnitt des Kontaktstiftes.

In einer ersten Variante des erfindungsgemäßen Kontaktsystems ist die zu jedem Kontaktstift jeweils gehörige erste Durchführung jeweils als gestufte Durchgangsbohrung im Gehäuse der Druckkammer realisiert, die einen ersten Abschnitt mit einem ersten Innendurchmesser und einen zweiten Abschnitt mit einem zweiten Innendurchmesser aufweist. Im Hinblick auf eine gute axiale Führung des innerhalb der ersten Durchführung axial bewegten Kontaktstiftes ist ein Teilabschnitt einer ersten Hülse in einem Teilabschnitt des zweiten Abschnitts der gestuften Durchgangsbohrung passgenau fixiert. Der Kontaktstift ist hierzu mit dem zweiten Abschnitt in der ersten Hülse axial bewegbar geführt. Der Vorteil der ersten Variante ist darin zu sehen, dass die erste Hülse vergleichsweise einfach aufgebaut und damit fertigbar ist.

In einer zweiten Variante des erfindungsgemäßen Kontaktsystems ist die zu jedem Kontaktstift jeweils gehörige erste Durchführung als Innenraum einer ersten Hülse realisiert, die passgenau in einer zugehörigen Durchgangsbohrung im Gehäuse der Druckkammer fixiert ist. Die erste Hülse weist wiederum einen ersten Abschnitt mit dem ersten Innendurchmesser und einen zweiten Abschnitt mit dem zweiten Innendurchmesser aufweist. Der Vorteil der zweiten Variante liegt darin, dass die erste Hülse und der darin steckende Kontaktstift als ein separierbares Kontaktmodul herstellbar sind, das vergleichsweise einfach in das Gehäuse der Druckkammer einbaubar ist.

In beiden Varianten des erfindungsgemäßen Kontaktsystems ist mindestens eine Öffnung in dem in der Druckkammer befindlichen Teilabschnitt des zweiten Abschnitts der ersten Hülse vorgesehen. Dieser Teilabschnitt des zweiten Abschnitts der ersten Hülse ist gleichzeitig vom zugehörigen Kontaktstift vakant. Auf diese Weise ist eine direkte Verbindung zwischen dem in der Druckkammer befindlichen Druckmedium und dem zur Druckkammer weisenden Ende des Kontaktstiftes möglich.

Zur elektrischen Verbindung des mit dem Kontaktstift zu kontaktierenden Kontaktpunktes mit einer Leiterplatte ist am Kontaktstift oder an der ersten Hülse eine Signalleitung befestigt.

Zur besseren Fixierung der ersten Hülse und damit des zugehörigen Kontaktstiftes im Gehäuse der Druckkammer ist dasjenige Ende der ersten Hülse, das vom zugehörigen Kontaktstift entfernt ist, bevorzugt jeweils in einer dritten Durchführung im Gehäuse der Druckkammer passgenau fixiert.

Im Hinblick auf eine Kontaktierung eines koaxialen Kontaktanschlusses auf einer integrierten Schaltung ist jeder Kontaktstift des Kontaktsystems um eine zum jeweiligen Kontaktstift koaxial angeordnete Kontaktbuchse erweitert. Hierzu sind um den jeweiligen Kontaktstift ein Isolatorteil und eine daran koaxial angeordnete zweite Durchführung vorgesehen, in der die Kontaktbuchse axial bewegbar ist.

Neben einem erfindungsgemäßen Kontaktsystem, das mindestens einen Kontaktstift, bevorzugt mehrere Kontaktstifte, enthält, ist von der Erfindung auch ein einzelnes erfindungsgemäßes Kontaktmodul mit abgedeckt, das eine erste Hülse und einen darin axial bewegbaren und pneumatisch ansteuerbaren Kontaktstift enthält. Die Merkmale der ersten Hülse und des Kontaktstiftes entsprechen hierbei den korrespondierenden Merkmalen im erfindungsgemäßen Kontaktsystem.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder ergänzend zu der jeweiligen Grundform der vorliegenden Erfindung hinzufügen.

### INHALTSANGABE DER ZEICHNUNG

Die vorliegende Erfindung wird nachfolgend anhand der in den schematischen Figuren der Zeichnung angegebenen Ausführungsbeispiele näher erläutert. Es zeigen dabei:
- Fig. 1A: eine Schnittdarstellung einer Ausführungsform eines erfindungsgemäßen Kontaktsystems mit eingefahrenen Kontaktstift,
- Fig. 1B: eine Schnittdarstellung einer Ausführungsform eines erfindungsgemäßen Kontaktsystems mit ausgefahrenen Kontaktstift,
- Fig. 2A: eine Längsschnittdarstellung einer ersten Ausführungsform eines erfindungsgemäßen Kontaktmoduls,
- Fig. 2B: eine Querschnittsdarstellung einer ersten Ausführungsform eines erfindungsgemäßen Kontaktmoduls,
- Fig. 3A: eine Längsschnittdarstellung einer zweiten Ausführungsform eines erfindungsgemäßen Kontaktmoduls,
- Fig. 3B: eine Querschnittsdarstellung einer zweiten Ausführungsform eines erfindungsgemäßen Kontaktmoduls,
- Fig. 4A: eine Längsschnittdarstellung einer koaxialen Ausführungsform eines erfindungsgemäßen Kontaktmoduls,
- Fig. 4B,4C: Querschnittdarstellungen einer koaxialen Ausführungsform eines erfindungsgemäßen Kontaktmoduls,
- Fig. 5: eine Schnittdarstellung einer weiteren Ausführungsform eines erfindungsgemäßen Kontaktsystems,
- Fig. 6A: eine Schnittdarstellung einer koaxialen Ausführungsform eines erfindungsgemäßen Kontaktsystems,
- Fig. 6B,6C: eine Draufsicht und eine Schnittdarstellung einer Gehäuseplatte für eine koaxiale Ausführungsform eines erfindungsgemäßen Kontaktsystems und
- Fig. 7: eine Schnittdarstellung einer weiteren Ausführungsform eines erfindungsgemäßen Kontaktsystems.

Die beiliegenden Figuren der Zeichnung sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts anderes ausgeführt ist - jeweils mit denselben Bezugszeichen versehen.

Im Folgenden werden die Figuren zusammenhängend und übergreifend beschrieben.

### BESCHREIBUNG VON AUSFÜHRUNGSBEISPIELEN

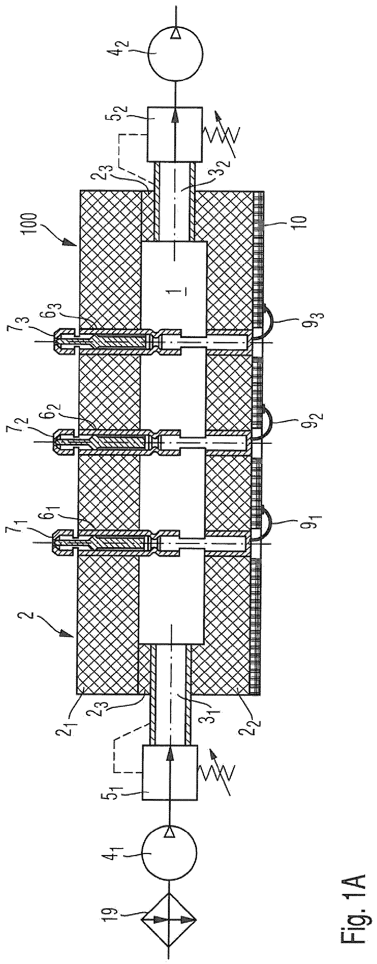

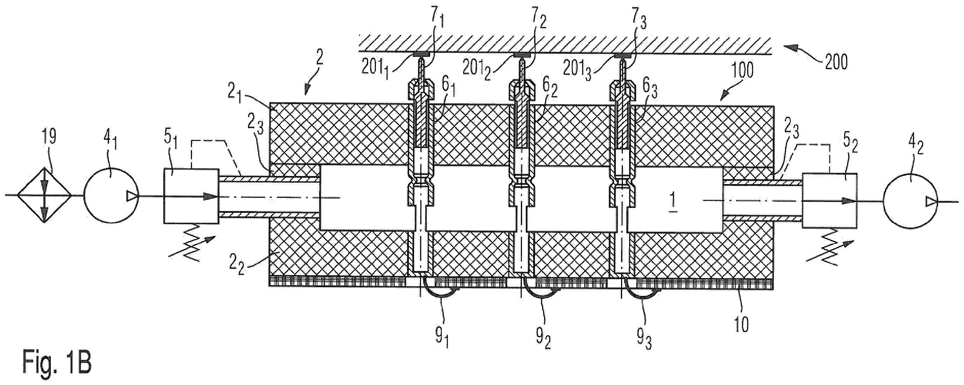

Eine erste Ausführungsform eines erfindungsgemäßen Kontaktsystems 100 wird im Folgenden anhand der Figuren 1A und 1B im Detail erläutert:
Das erfindungsgemäße Kontaktsystem weist eine Druckkammer 1 auf, die von einem Gehäuse 2 bevorzugt druckdicht abgeschlossen ist. In einer einfachen Realisierung weist das Gehäuse 2 eine obere Platte 2₁ und eine untere Platte 2₂ auf, die über Verbindungsstege 2₃ in einem gewissen Abstand zueinander beabstandet sind.

Die Realisierung des Gehäuses 2 aus zwei zueinander beabstandeten Platten eignet sich für Anwendungen, bei denen die einzelnen Kontaktstifte des Kontaktsystems auf einer einzigen Fläche zur Kontaktierung und Prüfung einer einzigen integrierten Schaltung angeordnet sind.

Von der Erfindung sind aber auch Gehäuseformen mit abgedeckt, bei denen mehrere Platten in einer bestimmten Orientierung zueinander eine Gehäuseoberfläche bilden und jeweils Kontaktstifte enthalten. Bei einem Gehäuse mit mehr als zwei Platten können gleichzeitig mehrere integrierte Schaltungen kontaktiert und geprüft werden.

Als Werkstoff für das Gehäuse 2 und seine einzelnen Bestandteile wird bevorzugt ein elektrisch isolierendes Material mit einer bestimmten mechanischen Tragfähigkeit verwendet.

Bei einem bevorzugten Gehäuse 2 mit zwei parallelen Platten 2₁ und 2₂ sind zwischen den Stegen 2₃ jeweils ein erster Zugang 3₁ und ein zweiter Zugang 3₂ vorgesehen. Über den ersten Zugang 3₁ wird von einer ersten Pneumatik-Pumpe 4₁ über ein erstes Druckregelventil 5₁ der Druckkammer 2 ein bestimmtes Volumen an Druckmedium, beispielsweise Luft, zugeführt, um ein bestimmtes erstes oder zweites Druckniveau, insbesondere ein gegenüber dem Außenraum der Druckkammer 1 erhöhtes Druckniveau, einzustellen. In Serie zur ersten Pneumatik-Pumpe 4₁ und zum ersten Druckregelventil 5₁ ist ein Temperaturregler 19 geschaltet, der die Temperatur des Druckmediums auf ein bestimmtes Temperaturniveau regelt.

Optional ist ein zweiter Zugang 3₂ vorgesehen, über den mittels einer zweiten Pneumatik-Pumpe 4₂ und eines zweiten Druckregelventils 5₂ ein bestimmtes Volumen an Druckmedium aus der Druckkammer 1 abgeführt wird, um ein bestimmtes zweites Druckniveau, insbesondere ein gegenüber dem Außenraum der Druckkammer reduziertes Druckniveau, d.h. ein Unterdruckniveau, einzustellen.

Das Gehäuse 2 der Druckkammer 1 weist mindestens eine erste Durchgangsbohrung 6₁, 6₂ und 6₃, bevorzugt mehrere Durchgangsbohrungen, auf, die in den Realisierungen in den Figuren 1A und 1B jeweils in der oberen Platte 2₁ des Gehäuses 2, angeordnet sind. In diesen Durchgangsbohrungen 6₁, 6₂ und 6₃ ist jeweils eine erste Ausführungsform eines Kontaktmoduls 7₁, 7₂ und 7₃ passgenau fixiert. Diese Kontaktmodule 7₁, 7₂ und 7₃ sind zusätzlich in zweiten Durchgangsbohrungen 8₁, 8₂ und 8₃, die gegenüberliegend den ersten Durchgangsbohrungen 6₁, 6₂ und 6₃ im Gehäuse 2, d.h. in der Realisierung in den Figuren 1A und 1B jeweils in der unteren Platte 2₂ des Gehäuses 2, passgenau fixiert. Dies dient zur zusätzlichen Stabilisierung der Kontaktmodule 7₁, 7₂ und 7₃ im Gehäuse 2 der Druckkammer 1.

An den Enden der Kontaktmodule 7₁, 7₂ und 7₃ sind jeweils Signalleitungen 9₁, 9₂ und 9₃, beispielsweise Drähte, Kabel und andere Übertragungselemente, mittels Löten, Bonden, Schweißen und anderen Verbindungstechnologien befestigt, die jeweils zu Kontaktpunkten oder Kontaktflächen an einer Leiterplatte 10 führen. Diese Leiterplatte 10 ist direkt an der unteren Platte 2₂ des Gehäuses 2 befestigt. Alternativ kann die Leiterplatte 10 auch in einem von der Druckkammer 10 entfernt positionierten Messgerät integriert sein.

In Fig. 1A sind die Kontaktstifte 12₁, 12₂ und 12₃ jeweils im eingefahrenen Zustand, d.h. im nicht kontaktierenden Zustand, dargestellt. In Fig. 1B sind die Kontaktstifte 12₁, 12₂ und 12₃ im ausgefahrenen Zustand dargestellt, in dem sie zugehörige Kontaktpunkte 201₁, 201₂ und 201₃ eines Gehäuses 200 der zu prüfenden integrierten Schaltung kontaktieren.

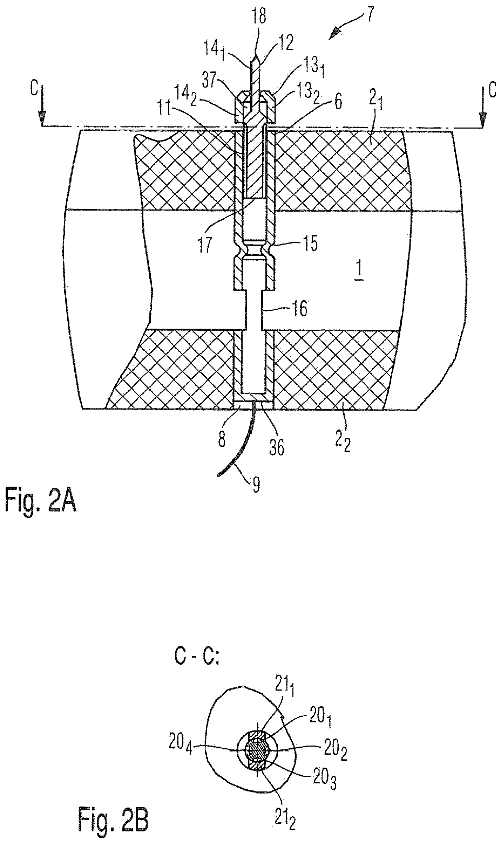

Die erste Ausführungsform des erfindungsgemäßen Kontaktmoduls 7, wird anhand der vergrößerten Darstellung in den Figuren 2A und 2B im Detail erläutert:
Die erste Ausführungsform des erfindungsgemäßen Kontaktmoduls 7 enthält eine erste Hülse 11, die jeweils passgenau in einer der ersten Durchgangsbohrungen 6₁, 6₂ und 6₃ in der gemäß Fig. 1A bzw. 1B jeweils oberen Platte 2₁ des Gehäuses 2 und in einer zugehörigen zweiten Durchgangsbohrung 8₁, 8₂ und 8₃ in der gemäß Fig. 1A bzw. 1B jeweils unteren Platte 2₂ des Gehäuses 2 fixiert ist.

Im Innenraum der ersten Hülse 11, der als erste Durchführung 37 dient, ist ein Kontaktstift 12 axial bewegbar geführt. Die erste Durchführung 37, d.h. der Innenraum der ersten Hülse 11, umfasst einen der Druckkammer 1 abgewandten ersten Abschnitt 13₁, der als Durchlass für einen ersten Abschnitt 14₁ des Kontaktstiftes im Zustand der Kontaktierung dient, und einen der Druckkammer 1 zugewandten und sich an den ersten Abschnitt 13₁ anschließenden zweiten Abschnitt 13₂, in dem ein an den ersten Abschnitt 14₁ sich anschließender zweiter Abschnitt 14₂ des Kontaktstiftes axial bewegbar geführt ist.

Der erste Innendurchmesser der ersten Hülse 11 im Bereich des ersten Abschnittes 13₁ der ersten Durchführung 37 ist bevorzugt etwas größer als der erste Außendurchmesser des ersten Abschnittes 14₁ des Kontaktstiftes 12, um ein Durchgleiten des Kontaktstiftes 12 durch die Innenbohrung der ersten Hülse 11 im Bereich des ersten Abschnitts 13₁ der ersten Durchführung 37 ohne Behinderung bzw. ohne Reibung zu garantieren.

Der zweite Innendurchmesser der ersten Hülse 11, d.h. der Innendurchmesser der ersten Durchführung 37, im Bereich des zweiten Abschnittes 13₂ der ersten Durchführung 37 entspricht dem zweiten Außendurchmesser des zweiten Abschnitts 14₂ des Kontaktstiftes 12, um ein Entweichen von Druckmedium aus der Druckkammer 1 in den Außenraum der Druckkammer 1 zu Beginn des Druckaufbaus in der Druckkammer 1 zu verhindern.

Zwischen der Innenwand der ersten Hülse 11 im Bereich des zweiten Abschnitts 13₂ der ersten Durchführung 37, dem ersten Abschnitt 14₁ des Kontaktstiftes 12, der druckkammerzugewandten Stirnfläche des der ersten Hülse 11 im Übergang zwischen dem ersten und dem zweiten Abschnitt der ersten Durchführung 37 und der druckkammerabgewandten Stirnfläche des zweiten Abschnitts 14₂ des Kontaktstiftes 12 bildet sich ein Hohlraum aus. Dieser Hohlraum ist mit kompressibler Luft gefüllt. Bei einer axialen Bewegung des Kontaktstiftes 12 innerhalb der ersten Hülse 11 in Richtung des zu kontaktierenden Gehäuses der zu prüfenden integrierten Schaltung wird die im Hohlraum befindliche Luft zusätzlich komprimiert. Sie wirkt damit wie ein dämpfendes Element auf den Kontaktstift 12. Somit benötigt das erfindungsgemäße Kontaktsystem keine Spiralfeder als dämpfendes Element, wie sie bei anderen Kontaktsystemen mit pneumatischer Ansteuerung der Kontaktstifte nach dem Stand der Technik eingesetzt wird.

Ab einer bestimmten Kompression der Luft im Hohlraum mit zunehmender axialer Bewegung des Kontaktstiftes 12 in der ersten Hülse 11 kann die Luft im Zwischenraum zwischen der ersten Hülse 11 im Bereich des ersten Abschnitts 13₁ der ersten Durchführung 37 und dem ersten Abschnitt 14₁ des Kontaktstiftes 12 in den Außenraum der Druckkammer 1 entweichen.

Die erste Hülse 11 weist im Bereich des zweiten Abschnitts 13₂ der ersten Durchführung 37, bevorzugt in dem Teilabschnitt des zweiten Abschnittes 13₂ der ersten Durchführung 37, der sich in der Druckkammer 1 befindet, eine radial nach innen gerichtete Schulter 15 auf, die als druckkammerzugewandter mechanischer Anschlag für den Kontaktstift 12 dient.

Die druckkammerzugewandte Stirnfläche der ersten Hülse 11 im Übergang zwischen dem ersten und zweiten Abschnitt der ersten Durchführung 37 dient als druckkammerabgewandter mechanischer Anschlag für den Kontaktstift.

Die erste Hülse 11 weist in dem Teilabschnitt des zweiten Abschnitts 13₂ der ersten Durchführung 37, der sich in der Druckkammer 1 befindet, mindestens eine Öffnung 16, bevorzugt mehrere Öffnungen, auf, durch die jeweils das in der Druckkammer befindliche Druckmedium in den Innenraum der ersten Hülse 11 und damit an das druckkammerzugewandte Ende 17 des Kontaktstiftes 12 gelangen kann. Der Kontaktstift 12 lässt sich somit auf eine bestimmte axiale Position innerhalb der ersten Hülse 11 positionieren, die zum Druckniveau des Druckmediums in der Druckkammer 1 korrespondiert und als erste axiale Position bezeichnet wird.

In diesem ausgefahrenen Zustand, der in Fig. 1B dargestellt ist, ragt der erste Abschnitt 14₁ jedes Kontaktstiftes 12₁, 12₂ und 12₃ über die erste Hülse 13 hinaus und kontaktiert mit seiner zugehörigen Prüfspitze 18 den zugehörigen Kontaktpunkt 201₁, 201₂ und 201₃ am Gehäuse 200 der zu prüfenden integrierten Schaltung. Dieses Druckniveau entspricht einem ersten Druckniveau, das durch die erste Pneumatik-Pumpe 4₁ und das erste Druckregelventil 5₁ eingestellt wird.

Im eingefahrenen Zustand, der in Fig. 1A dargestellt ist, befindet sich der einzelne Kontaktstift 12₁, 12₂ und 12₃ in einer axialen Position innerhalb der ersten Hülse 11, die sich gegenüber der ersten axialen Position näher an der Druckkammer 1 befindet. Diese Position wird als zweite axiale Position bezeichnet. In dieser zweiten axialen Position ist die Prüfspitze 18 nicht mehr im Kontakt mit dem zugehörigen Kontaktpunkt am Gehäuse der integrierten Schaltung. Der erste Abschnitt 14₁ des Kontaktstiftes 12 kann hierbei über den ersten Abschnitt 13₁ der ersten Durchführung 37 hinausragen oder sich innerhalb des ersten Abschnittes 13₁ oder sich innerhalb des zweiten Abschnitts 13₁ der ersten Durchführung 37 befinden.

Dieses Druckniveau entspricht einem zweiten Druckniveau, das in einem ersten Fall gegenüber dem ersten Druckniveau reduziert ist und ebenfalls durch die erste Pneumatik-Pumpe 4₁ und das erste Druckregelventil 5₁ eingestellt wird.

In einem zweiten Fall entspricht das zweite Druckniveau dem Druckniveau im Außenraum der Druckkammer 1 und wird durch Ausschalten der ersten Pneumatik-Pumpe 4₁ und/oder durch Druckregelung auf Umgebungsdruckniveau durch das erste Druckregelventil 5₁ realisiert. Im ersten und zweiten Fall kehrt der Kontaktstift 12 aufgrund der Schwerkraft von der ersten axialen Position in die zweite axiale Position. In einem dritten Fall entspricht das zweite Druckniveau einem Unterdruckniveau in Relation zur Umgebungsdruckniveau im Außenraum der Druckkammer 1.

Im dritten Fall wird in der Druckkammer 1 ein Unterdruckniveau gegenüber dem Umgebungsdruckniveau im Außenraum der Druckkammer 1 durch die zweite Pneumatik-Pumpe 4₂ und das zweite Druckregelventil 5₂ realisiert. Dieser dritte Fall wird insbesondere dann angewandt, wenn der Kontaktstift 12 aufgrund seiner Lage zur Druckkammer 1 keine Schwerkraft in Richtung der Druckkammer 1 erfährt. Dies liegt beispielsweise vor, wenn er horizontal zur Druckkammer 1 in einer ersten Hülse 11 in einer Seitenplatte im Gehäuse 2 oder wenn er unterhalb der Druckkammer 1 in einer ersten Hülse 11 in einer unteren Platte 22 axial bewegbar gelagert ist.

Dasjenige Ende 18 der ersten Hülse 11, das vom Kontaktstift 12 entfernt ist, ist bevorzugt in einer dritten Durchführung 8 im Gehäuse 2, bevorzugt in einer Gehäuseplatte 2₂ des Gehäuses 2, passgenau fixiert. In einer derartigen bevorzugten Realisierung ist das Ende 18 der ersten Hülse 11 geschlossen. Eine Signalleitung 9 ist mittels der oben genannten Verbindungstechnologien an diesem Ende 18 der ersten Hülse 11 befestigt.

In einer alternativen Realisierung endet das vom Kontaktstift 12 entfernte Ende 36 der ersten Hülse 11 in der Druckkammer 1. Ein bei dieser alternativen Realisierung am Ende 18 der ersten Hülse 11 befestigte Signalleitung 9 wird über eine abgedichtete Bohrung im Gehäuse 2, die in allen Figuren nicht dargestellt ist, in den Außenraum der Druckkammer 1 geführt und mit einem Kontaktpunkt einer Leiterplatte 10 verbunden.

Indem das der Prüfspitze 18 abgewandte Ende 17 des Kontaktstiftes 12 im direkten Kontakt mit dem temperaturgeregelten Druckmedium der Druckkammer 1 steht, erfolgt ein Wärmeübergang zwischen dem Druckmedium der Druckkammer 1 und dem Kontaktstift 12. Auf diese Weise lässt sich über eine Temperaturregelung des Druckmediums die Temperatur des Kontaktstiftes 12 an das Temperaturniveau des Gehäuses der zu prüfenden integrierten Schaltung angleichen. Eine unerwünschte Wärmeabfuhr vom Gehäuse der integrierten Schaltung zum Kontaktstift 12 bzw. eine unerwünschte Wärmezufuhr vom Kontaktstift 12 zum Gehäuse der integrierten Schaltung lässt sich damit vorteilhaft vermeiden.

Die integrierte Schaltung bzw. das Gehäuse der integrierten Schaltung verharrt damit im Idealfall auf der eingestellten Prüftemperatur. Wird die integrierte Schaltung in Temperaturzyklen getestet, wie sie beispielsweise bei Burn-In-Tests durchgeführt werden, so ist der Temperaturregler 19 zur Regelung der Temperatur des Druckmediums mit denselben Temperaturzyklen zu betreiben.

Ein schnelleres Folgen des Kontaktstiftes 12 auf das geänderte Temperaturniveau des Druckmediums in der Druckkammer 1 erfolgt dadurch, dass innerhalb des Kontaktstiftes 12 mindestens ein erster Luftkanal 20₁, 20₂, 20₃ und 20₄ vorgesehen ist. Jeder dieser ersten Luftkanäle 20₁, 20₂, 20₃ und 20₄ erstreckt sich jeweils vom druckkammerzugewandten Ende 17 des Kontaktstiftes 12 über eine bestimmte Längserstreckung im zweiten Abschnitt 13₂ des Kontaktstiftes.

In der in den Figuren 2A und 2B dargestellten ersten Ausführungsform eines erfindungsgemäßen Kontaktmoduls 7 sind die einzelnen ersten Luftkanäle 20₁, 20₂, 20₃ und 20₄ jeweils als eine Ausnehmung an der Zylinderaußenmantelfläche des Kontaktstiftes 12 realisiert. Jede Ausnehmung ist jeweils von einer Innenwandung der ersten Hülse 11 im Bereich des zweiten Abschnitts 13₂ der ersten Durchführung 37 verschlossen. Die einzelnen Ausnehmungen der ersten Luftkanäle 20₁, 20₂, 20₃ und 20₄ sind jeweils bevorzugt in äquidistanten Winkelabständen zueinander angeordnet.

Zwischen dem zweiten Abschnitt 13₂ der ersten Durchführung 37, d.h. dem Innenraum der ersten Hülse 11 im Bereich des zweiten Abschnitts 13₂ der ersten Durchführung 37, und dem Außenraum der Druckkammer 1 verlaufen mehrere ebenfalls in äquidistanten Winkelabschnitten zueinander angeordnete zweite Luftkanäle 21₁ und 21₂. Die Anzahl der zweiten Luftkanäle 21₁ und 21₂ ist gegenüber der Anzahl von ersten Luftkanälen 20₁, 20₂, 20₃ und 20₄ reduziert. Auf diese Weise ist gewährleistet, dass bei jeder beliebigen Orientierung des Kontaktstiftes 12 innerhalb der ersten Hülse 11 und bei einer bestimmten axialen Position des Kontaktstiftes 12 in der zugehörigen ersten Hülse 11 jeder zweiten Luftkanal 21₁ und 21₂ zumindest teilweise mit mindestens einem der ersten Luftkanäle 20₁, 20₂, 20₃ und 20₄ verbunden ist.

Auf diese Weise liegt mindestens eine der Anzahl von zweiten Luftkanälen 21₁ und 21₂ entsprechende Anzahl von direkten Luftverbindungen zwischen der Druckkammer 1 und dem Außenraum der Druckkammer 1 vor.

Die axiale Position des Kontaktstiftes 12 in der zugehörigen ersten Hülse 11 ist im kontaktierenden Zustand des Kontaktstiftes 12 abhängig von der Lage des Gehäuses der integrierten Schaltung zum Kontaktsystem und kann über einen bestimmten Bereich variieren. Somit ist die Längserstreckung jedes ersten Luftkanals 20₁, 20₂, 20₃ und 20₄ im zweiten Abschnitt 14₂ des Kontaktstiftes 12 und die axiale Position der zweiten Luftkanäle 21₁ und 21₂ durch die erste Hülse 11 im zweiten Abschnitt 13₂ der ersten Durchführung 37 so auszulegen, dass eine direkte Verbindung zwischen jedem zweiten Luftkanal und mindestens einem der ersten Luftkanäle verwirklicht ist. Insbesondere ist die Längserstreckung jedes ersten Luftkanals 20₁, 20₂, 20₃ und 20₄ im zweiten Abschnitt 14₂ des Kontaktstiftes 12 ausreichend lang zu gestalten.

Durch die direkte Luftverbindung zwischen den einzelnen ersten Luftkanälen 20₁, 20₂, 20₃ und 20₄ und den zugehörigen zweiten Luftkanälen 21₁ und 21₂ kommt es jeweils zu einem Luftstrom des temperierten Druckmediums zwischen der Druckkammer 1 und dem Außenraum der Druckkammer 1. Dieser Luftstrom verursacht zusätzlich eine Wärmekonvektion zwischen dem temperierten Druckmedium und dem Kontaktstift 12, die ein beschleunigtes Temperieren des Kontaktstiftes 12 auf das Temperaturniveau des Druckmediums ermöglicht. Diese Wärmekonvektion erstreckt sich über die gesamte Längserstreckung der einzelnen ersten Luftkanäle 20₁, 20₂, 20₃ und 20₄ innerhalb des Kontaktstiftes 12.

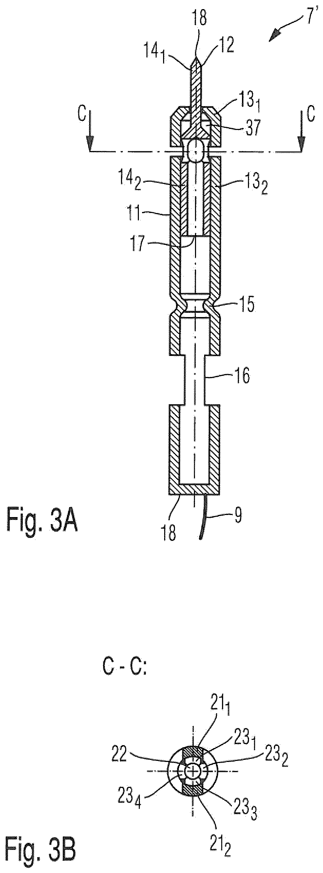

In den Figuren 3A und 3B ist eine zweite Ausführungsform eines erfindungsgemäßen Kontaktmoduls 7' dargestellt. Identische Merkmale zur ersten Ausführungsform weisen identische Bezugszeichen auf und werden nicht mehr wiederholt beschrieben.

Bei der zweiten Ausführungsform des erfindungsgemäßen Kontaktmoduls 7' werden die ersten Luftkanäle 20₁, 20₂, 20₃ und 20₄ durch eine für alle ersten Luftkanäle 20₁, 20₂, 20₃ und 20₄ jeweils gemeinsame erste Bohrung 22 in Längsrichtung des Kontaktstiftes 12 und durch jeweils eine zweite Bohrung 22₁, 22₂, 22₃ und 22₄ in Querrichtung des Kontaktstiftes 12 realisiert.

Die gemeinsame erste Bohrung 22 verläuft im Innern des Kontaktstiftes, bevorzugt im Zentrum des Kontaktstiftes 12, vom druckkammerzugewandten Ende 17 des Kontaktstiftes 12 über eine bestimmte Längserstreckung im zweiten Abschnitt 14₂ des Kontaktstiftes 12. Am Ende dieser Längserstreckung der ersten Bohrung 22 führen mehrere zweite Bohrungen 23₁, 23₂, 23₃ und 23₄, die bevorzugt in äquidistanten Winkelabschnitten angeordnet sind, vom Innern zur Außenmantelfläche des Kontaktstiftes 12.

Zweite Luftkanäle 21₁ und 21₂ in der ersten Hülse 11 zwischen dem zweiten Abschnitt 13₂ der ersten Durchführung 37 und dem Außenraum der Druckkammer 1 sind bevorzugt in äquidistanten Winkelabschnitten zueinander angeordnet. Die Anzahl der zweiten Luftkanäle 21₁ und 21₂ ist ebenfalls gegenüber der Anzahl von ersten Luftkanälen 20₁, 20₂, 20₃ und 20₄ reduziert. Auf diese Weise ist ebenfalls gewährleistet, dass bei jeder beliebigen Orientierung des Kontaktstiftes 12 innerhalb der ersten Hülse 11 und bei einer bestimmten axialen Position des Kontaktstiftes 12 in der zugehörigen ersten Hülse 11 jeder zweiten Luftkanal 21₁ und 21₂ zumindest teilweise mit mindestens einem zweiten Bohrung 23₁, 23₂, 23₃ und 23₄ eines ersten Luftkanals 20₁, 20₂, 20₃ und 20₄ verbunden ist. Auf diese Weise liegt ebenfalls mindestens eine der Anzahl von zweiten Luftkanälen 21₁ und 21₂ entsprechende Anzahl von direkten Luftverbindungen zwischen der Druckkammer 1 und dem Außenraum der Druckkammer 1 vor.

Die zweiten Bohrungen 23₁, 23₂, 23₃ und 23₄ weisen bevorzugt jeweils ein elliptisches Querschnittsprofil auf, wobei die längere Achse des elliptischen Querschnittsprofils in Längsrichtung des Kontaktstiftes 12 und die kürzere Achse des elliptischen Querschnittsprofils in Umfangrichtung des Kontaktstiftes 12 sich erstrecken.

Auf diese Weise ist gewährleistet, dass bei unterschiedlichen axialen Positionen des Kontaktstiftes 12 innerhalb der ersten Hülse 11 im Fall von unterschiedlichen Abständen der zu kontaktierenden Kontaktpunkte zum Kontaktsystem immer jeweils eine Luftverbindung zwischen jedem zweiten Luftkanal 21₁ und 21₂ und jeweils mindestens einer zweiten Bohrung 23₁, 23₂, 23₃ und 23₄ eines ersten Luftkanals 20₁, 20₂, 20₃ und 20₄ realisiert ist.

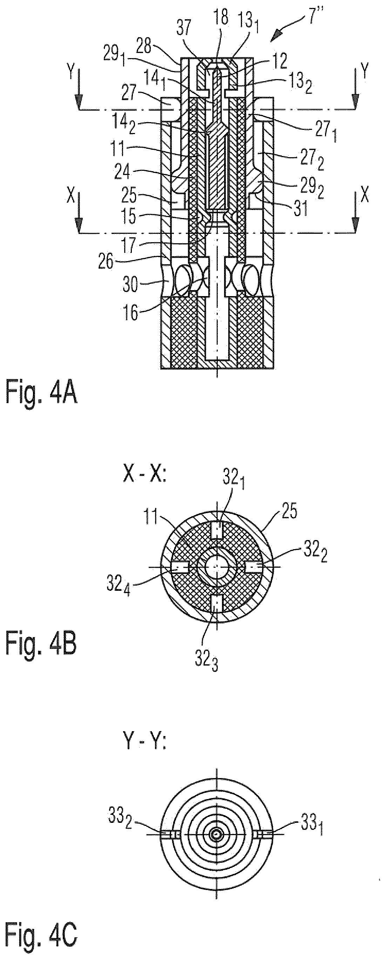

Im Folgenden wird eine dritte Ausführungsform eines erfindungsgemäßes Kontaktmodul 7" mit einem Kontaktstift und einer Kontaktbuchse zur Kontaktierung eines koaxialen Kontaktes am Gehäuse der integrierten Schaltung anhand der Figuren 4A, 4B und 4C erläutert:
Die den Kontaktstift 12 und die zugehörigen erste Hülse 11 betreffenden Merkmale entsprechen den Merkmalen des in den Figuren 2A, 2B, 3A und 3B jeweils vorgestellten Ausführungsformen eines erfindungsgemäßen Kontaktmoduls zur Kontaktierung eines einzigen Kontaktpunktes am Gehäuse der integrierten Schaltung und werden im Folgenden nicht wiederholt erläutert.

Koaxial zur ersten Hülse 11 sind ein Isolatorteil 24 und eine zweite Durchführung 25 angeordnet. Die zweite Durchführung 25 ist hierbei als hülsenförmiger Zwischenraum zwischen einer zweiten Hülse 26 und dem Isolatorteil 24 ausgebildet. In der zweiten Durchführung 25 ist eine Kontaktbuchse 28 axial bewegbar geführt.

In einem der Druckkammer 1 abgewandten ersten Abschnitt 27₁ der zweiten Durchführung 25 weist die zweite Hülse 26 in einer bevorzugten Ausprägung einem ersten Innendurchmesser und in einen der Druckkammer 1 zugewandten zweiten Abschnitt 27₂ der zweiten Durchführung 25 einen gegenüber dem ersten Innendurchmesser größeren zweiten Innendurchmesser auf.

Diese Kontaktbuchse 28 weist einen ersten, der Druckkammer 1 abgewandten ersten Abschnitt 29₁ und einen sich an den ersten Abschnitt 29₁ anschließenden zweiten Abschnitt 29₂ auf. Der Außendurchmesser des ersten Abschnittes 29₁ ist gegenüber dem Außendurchmesser des zweiten Abschnittes 29₂ verkleinert.

Der Außendurchmesser des zweiten Abschnittes 29₂ der Kontaktbuchse 28 entspricht dem Innendurchmesser der zweiten Hülse 26 im zweiten Abschnitt 27₂ der zweiten Durchführung 25. Der Außendurchmesser des ersten Abschnittes 29₁ der Kontaktbuchse 28 entspricht in der in den Figuren 4A, 4B und 4C dargestellten Variante eines erfindungsgemäßen Kontaktmoduls 7" dem Innendurchmesser der zweiten Hülse 26 im ersten Abschnitt 27₁ der zweiten Durchführung 25.

Auf Höhe der in der ersten Hülse 11 jeweils vorgesehenen Öffnungen 16, d.h. in einem Teilabschnitt des Kontaktmoduls 7", der sich innerhalb der Druckkammer 1 befindet, sind auch in der zweiten Hülse 26 Öffnungen 30 vorgesehen. Bevorzugt entspricht die Anzahl der Öffnungen 16 in der ersten Hülse 11 der Anzahl der Öffnungen 30 in der zweiten Hülse 26. Außerdem sind die Öffnungen 30 in der ersten Hülse 26 bevorzugt in einer gleichen Phasenlage wie die Öffnungen 16 in der ersten Hülse 11 angeordnet, um das in der Druckkammer 1 befindliche Druckmedium in der gleichen Weise an das der Druckkammer 1 zugewandte Ende 17 des Kontaktstiftes 12 und an das der Druckkammer 1 zugewandte Ende 31 der Kontaktbuchse 28 zu führen.

Das Isolatorteil 24 erstreckt sich in Längsrichtung der ersten Durchführung 37 bzw. der zweiten Durchführung 25 von den Öffnungen 16 in der ersten Hülse 11 bis zu den zweiten Luftkanälen 21₁ und 21₂ durch die ersten Hülse 11 im Bereich des zweiten Abschnitts 13₂ der ersten Durchführung 37. Einzig im Bereich zwischen den Öffnungen 16 der ersten Hülse 11 bzw. den Öffnungen 30 der zweiten Hülse 26 und dem der Druckkammer 1 zugewandte Ende 31 der Kontaktbuchse 28 erstreckt sich das Isolatorteil 24, wie aus Fig. 4B hervorgeht, in Querrichtung zwischen erster und zweiter Hülse 11 und 28, um erste und zweite Hülse 11 und 28 zueinander abzustützen.

Damit ein Druckmedium von der Druckkammer 1 über die Öffnungen 30 in der zweiten Hülse 28 zum druckkammerzugewandten Ende 31 der Kontaktbuchse 28 gelangen kann, sind im Isolatorteil 24 im Bereich zwischen den Öffnungen 30 der zweiten Hülse 26 und dem der Druckkammer 1 zugewandte Ende 31 der Kontaktbuchse 28 mehrere, bevorzugt in äquidistanten Winkelabschnitten jeweils angeordnete Durchgänge 32₁, 32₂, 32₃ und 32₄ vorgesehen. Diese Durchgänge 32₁, 32₂, 32₃ und 32₄ sind bevorzugt als Schlitze realisiert. Alternativ können andere Querschnittsprofile für die Durchgänge 32₁, 32₂, 32₃ und 32₄ realisiert werden. Die Anzahl Durchgänge 32₁, 32₂, 32₃ und 32₄ ist geeignet zu wählen.

Zwischen der Innenwand der zweiten Hülse 26 im zweiten Abschnitt 27₂ der zweiten Durchführung 25, der Außenzylinderaußenmantelfläche des ersten Abschnitts 29₁ der Kontaktbuchse 28, dem druckkammerzugewandten Stirnfläche der zweiten Hülse 26 im Übergang zwischen dem ersten und zweiten Abschnitt der zweiten Durchführung 25 und der druckkammerabgewandten Stirnfläche des zweiten Abschnitts 29₂ der Kontaktbuchse 28 bildet sich ebenfalls analog wie beim Kontaktstift 12 ein Hohlraum mit einer kompressibler Luft aus. Die Kompressibilität der Luft realisiert hierbei die dämpfende Wirkung einer Spiralfeder, die erfindungsgemäß für die Kontaktbuchse 28 nicht erforderlich ist.

Ein Entweichen der im Hohlraum befindlichen Luft in den Außenraum der Druckkammer 1 bei einer zusätzlichen axialen Bewegung der Kontaktbuchse 28 in Richtung der zu kontaktierenden Kontaktpunkts am Gehäuse der integrierten Schaltung wird, wie in Fig. 4C dargestellt ist, über mindestens einen Durchgang 33₁, bevorzugt mehrere Durchgänge 33₁ und 33₂, in der zweiten Hülse 26 im Bereich des ersten Abschnitts 27₁ der zweiten Durchführung 25 verwirklicht. Diese Durchgänge 33₁ und 33₂ können bevorzugt schlitzförmig ausgeführt sein. Alternativ kann ein Entweichen der im Hohlraum befindlichen Luft in den Außenraum der Druckkammer 1 auch über einen Durchgang realisiert werden, der sich durch einen Innendurchmesser der zweiten Hülse 26 im Bereich des ersten Abschnitts 27₁ der zweiten Durchführung 25 ausbildet, welcher gegenüber dem Außendurchmesser des ersten Abschnitts 29₁ der Kontaktbuchse 28 verkleinert ist.

In einer weiteren Ausführungsform ist die zweite Hülse 26 auf den zweiten Abschnitt 27₂ der zweiten Durchführung 25 beschränkt. Im Bereich des ersten Abschnitts 27₁ der zweiten Durchführung 25 ist eine separate dritte Hülse vorgesehen, die die gleiche Geometrie und die gleichen Ausprägungen aufweist, wie sie obig für die zweite Hülse 26 im Bereich des ersten Abschnitts 27₁ der zweiten Durchführung 25 benannt wurden. Die dritte Hülse ist hierbei mittels Presspassung, Klebung oder Schraubung mit der zweiten Hülse 26 und/oder der Innenwandung der jeweiligen Durchgangsbohrung 6₁, 6₂ und 6₃ im Gehäuse 2 der Druckkammer 1 verbunden.

Eine Temperierung der Kontaktbuchse 28 auf das Temperaturniveau der Druckkammer 1 erfolgt einerseits durch einen Wärmeübergang vom Druckmedium innerhalb der zweiten Hülse 26 auf die Kontaktbuchse 28 am druckkammerzugewandte Ende 31 der Kontaktbuchse 28. Andererseits wird die Kontaktbuchse 28 zusätzlich durch Luftströme temperiert, die durch die einzelnen ersten Luftkanäle 20₁, 20₂, 20₃ und 20₄ des Kontaktstiftes 12 und durch die zweiten Luftkanäle 21₁ und 21₂ durch die erste Hülse 11 geführt und entlang der Innenwand des ersten Abschnitts 29₁ der Kontaktbuchse 28 geleitet werden.

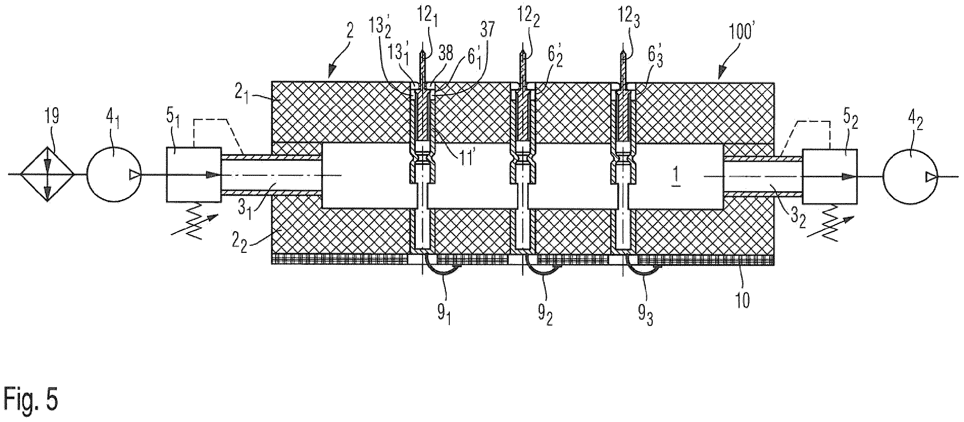

Eine zweite Ausführungsform eines erfindungsgemäßen Kontaktsystems 100' wird im Folgenden anhand der Fig. 5 beschrieben:
Im Gehäuse 2 der Druckkammer 1 ist für jeden Kontaktstift 12₁, 12₂ und 12₃ jeweils eine Durchgangsbohrung 6₁', 6₂' und 6₃' vorgesehen, deren Innenraum jeweils als eine weitere Ausführungsform einer ersten Durchführung 37' für den zugehörigen Kontaktstift 12₁, 12₂ und 12₃ dient. Jede dieser ersten Durchführungen 37', d.h. jeder Innenraum einer Durchgangsbohrung 6₁', 6₂' und 6₃', weist jeweils einen druckkammerabgewandten ersten Abschnitt 13₁' mit einem kleineren Innendurchmesser und einen druckkammerzugewandten zweiten Abschnitt 13₂' mit einem größeren Innendurchmesser auf.

Jede Durchgangsbohrung 6₁', 6₂' und 6₃' kann somit einerseits als gestufte Durchgangsbohrung realisiert werden.

Eine andere Realisierung, wie sie in Fig. 5 dargestellt ist, enthält eine Durchgangsbohrung mit jeweils einem größeren, dem Innendurchmesser des zweiten Abschnitts 13₂' der ersten Durchführung 37' entsprechenden Innendurchmesser und jeweils eine dritte Hülse 38 mit einem kleineren, dem Innendurchmesser des ersten Abschnitts 13₁' der ersten Durchführung 37' entsprechenden Innendurchmesser. Die dritte Hülse 38 ist an dem druckkammerabgewandten Ende der jeweiligen Durchgangsbohrung passgenau an der Durchgangsbohrung fixiert. Die Fixierung der dritten Hülse 38 an der jeweiligen Durchgangsbohrung erfolgt beispielsweise durch Presspassung, Klebung oder Schraubung.

In einem druckkammerzugewandten Teilabschnitt des zweiten Abschnitts 13₂' der ersten Durchführung 37', d.h. der Durchgangsbohrung, ist ein Teilabschnitt einer zweiten Ausführungsform einer ersten Hülse 11' passgenau fixiert. Die zweite Ausführungsform der ersten Hülse 11' ist eine in Richtung des Gehäuses der zu prüfenden integrierten Schaltung offene Hülse und entspricht in Richtung der Druckkammer 1 der ersten Ausführungsform der ersten Hülse 11. Der Kontaktstift 12 ist in Analogie zur ersten Ausführungsform der ersten Hülse 11 axial bewegbar in der ersten Hülse 11' geführt.

Somit bildet der Innenraum der dritten Hülse 38 den ersten Abschnitt 13₁' der ersten Durchführung 37', der einen Durchlass für den Kontaktstift 12 zur Kontaktierung eines Kontaktpunktes am Gehäuse einer integrierten Schaltung bietet. Der Teilabschnitt der Durchgangsbohrung, der nicht von der dritten Hülse 38 belegt ist, und der Innenraum der ersten Hülse 11' bilden zusammen den zweiten Abschnitt 13₂' der ersten Durchführung 37', in dem der Kontaktstift 12₁, 12₂ und 12₃ axial bewegbar geführt ist.

Jeder Kontaktstift 12₁, 12₂ und 12₃ weist jeweils mehrere erste Luftkanäle 20₁, 20₂, 20₃ und 20₄ auf, die jeweils als Ausnehmung an der Zylindermantelaußenfläche des zweiten Abschnitts 14₂ des jeweiligen Kontaktstiftes 12₁, 12₂ und 12₃ vom druckkammerzugewandten Ende 17 über eine bestimmte Längserstreckung realisiert sind. Diese Ausnehmungen sind an ihrem druckkammerabgewandten Ende jeweils konisch oder kegelstumpfförmig ausgeführt. Luftströme durch die ersten Luftkanäle 20₁, 20₂, 20₃ und 20₄ strömen gleichmäßig durch zweite Luftkanäle, die als Durchgänge in der dritten Hülse 38 realisiert sind. Diese Durchgänge in der dritten Hülse 38 sind äquivalent wie die in Fig. 4C dargestellten Durchgänge 33₁ und 33₂ in der zweiten Hülse 26 im Bereich des ersten Abschnitts 27₁ der zweiten Durchführung 25 ausgeführt. Auf diese Weise wird einerseits eine Zentrierung des jeweiligen Kontaktstiftes 12₁, 12₂ und 12₃ in der ersten Durchführung 37' verwirklicht. Andererseits wird über Wärmekonvektion eine beschleunigte Temperierung des jeweiligen Kontaktstiftes 12₁, 12₂ und 12₃ an das Temperaturniveau des Druckmediums 1 verwirklicht.

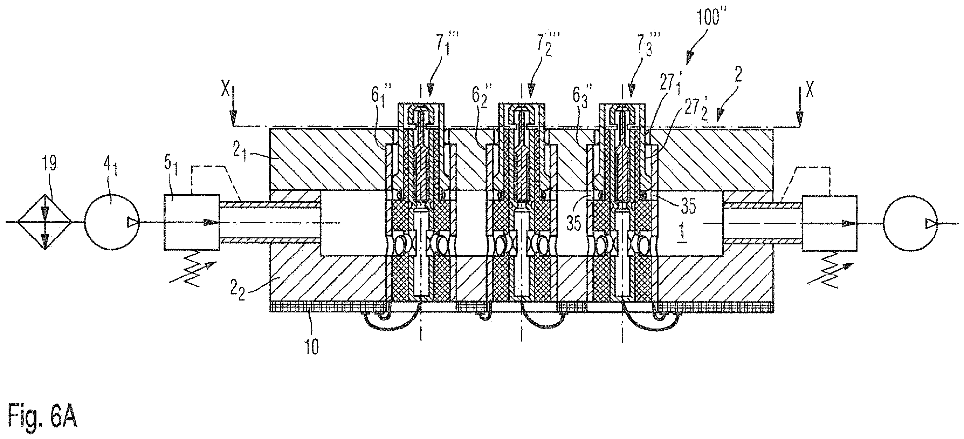

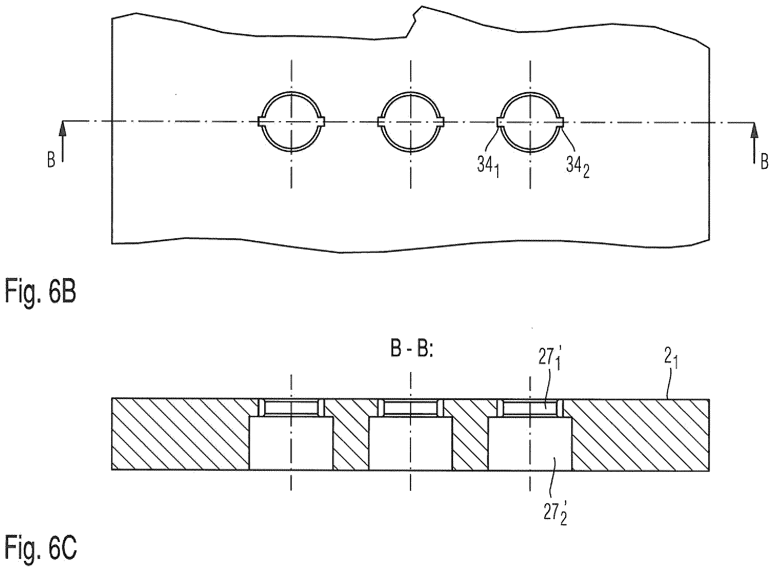

In den Figuren 6A, 6B, und 6C ist eine dritte Ausführungsform eines erfindungsgemäßen Kontaktsystem 100'' dargestellt. Im Gehäuse 2 der Druckkammer 1 ist für jedes Kontaktmodul 7₁''', 7₂'" und 7₃"" jeweils eine erste Durchgangsbohrung 6₁'', 6₂'' und 6₃'' vorgesehen, die strukturell den in der zweiten Ausführungsform des erfindungsgemäßen Kontaktsystems 100'' vorgestellten ersten Durchgangsbohrung 6₁', 6₂' und 6₃' entsprechen. Da die ersten Durchgangsbohrungen 6₁'', 6₂'' und 6₃'' der dritten Ausführungsform des erfindungsgemäßen Kontaktsystems 100'' für Kontaktmodule 7₁'", 7₂"' und 7₃"" aus jeweils einem Kontaktstift und einer Kontaktbuchse verwendet werden und somit lediglich einen größeren Durchmesser aufweisen, wird an dieser Stelle auf eine detaillierte wiederholte Beschreibung verzichtet und auf die korrespondierende Beschreibung zu den ersten Durchgangsbohrungen 6₁', 6₂' und 6₃' bei der zweiten Ausführungsform des erfindungsgemäßen Kontaktsystems 100'' verwiesen. Auch die äußere Beschaltung der Druckkammer 1 ändert sich bei der dritten Ausführungsform gegenüber der ersten und zweiten Ausführungsform des erfindungsgemäßen Kontaktsystems nicht, sodass auch hier auf eine detaillierte Beschreibung verzichtet wird und diesbezüglich auf die Beschreibung zur ersten und zweiten Ausführungsform verwiesen wird.

Die in der dritten Ausführungsform des erfindungsgemäßen Kontaktsystem 100'' verwendete dritte Ausführungsform eines Kontaktmoduls 7₁'", 7₂" ' und 7₃'" mit jeweils einem Kontaktstift und einer Kontaktbuchse ähnelt der zweiten Ausführungsform eines Kontaktmoduls 7'' gemäß der Figuren 4A bis 4C, sodass nur die Unterschiede im Folgenden erläutert werden:
Jedes Kontaktmodul 7₁'", 7₂'" und 7₃'" der dritten Ausführungsform ist in einer zugehörigen gestufte Durchgangsbohrung 6₁", 6₂" und 6₃" passgenau fixiert.

Der Zwischenraum zwischen der gestufte Durchgangsbohrung 6₁", 6₂" und 6₃" und dem Isolatorteil 24 des zugehörigen Kontaktmoduls 7₁'", 7₂'" und 7₃" ' bildet dabei eine zweite Durchführung 25'. Diese zweite Durchführung 25' weist gemäß Fig. 6C einen druckkammerabgewandten ersten Abschnitt 27₁' mit einem ersten Innendurchmesser und einen druckkammerzugewandten zweiten Abschnitt 27₂' mit einem gegenüber dem ersten Innendurchmesser größeren zweiten Innendurchmesser auf.

In der Zylinderinnenwandung der gestuften Durchgangsbohrungen 6₁'', 6₂'' und 6₃'' im Bereich des ersten Abschnitts 27₁' der zweiten Durchführung 25' sind gemäß Fig. 6B mehrere, bevorzugt in äquidistanten Winkelabschnitten angeordnete und in Längsrichtung der zweiten Durchführung verlaufende Ausnehmungen 34₁ und 34₂ vorgesehen. Diese ermöglichen ein Entweichen der im Hohlraum zwischen der zweiten Hülse 26, dem ersten Abschnitt 29₁ der Kontaktbuchse 28 der druckkammerabgewandten Stirnfläche des zweiten Abschnitts 29₂ der Kontaktbuchse 28 und der druckkammerzugewandten Stirnfläche der jeweiligen gestuften Durchgangsbohrung 6₁", 6₂" und 6₃" im Übergang zwischen dem ersten und dem zweiten Abschnitt der zweiten Durchführung 25' befindlichen Luft in den Außenraum der Druckkammer 1.

Die zweite Hülse 26 jedes Kontaktmoduls 7₁''', 7₂'" und 7₃'" ist dabei vollständig im Bereich des zweiten Abschnitt 27₂' der zweiten Durchführung 25' in die gestufte Durchgangsbohrung 6₁'", 6₂'" und 6₃'" eingefügt.

Die Kontaktbuchse 28 ist in der zugehörigen zweiten Durchführung 25' axial bewegbar.

In der dritten Ausführungsform des erfindungsgemäßen Kontaktmoduls 7₁'", 7₂'" und 7₃'" sind zusätzlich zu den Öffnungen 30 in Richtung der Kontaktbuchse 28 zusätzliche Öffnungen 35 in der zweiten Hülse 28 vorgesehen. Diese zusätzlichen Öffnungen 35 ermöglicht die Verwendung eines Isolatorteiles 24, so dass im Bereich zur gegenseitigen Stützung der ersten und zweiten Hülse 11 und 28 keine Durchgänge 32₁, 32₂, 32₃ und 32₄ erforderlich sind.

Die restlichen Merkmale der dritten Ausführungsform des erfindungsgemäßen Kontaktmoduls 7₁''', 7₂'" und 7₃"' entsprechen der zweiten Ausführungsform des erfindungsgemäßen Kontaktmoduls 7" und werden deshalb an dieser Stelle nicht mehr im Einzelnen erläutert.

An dieser Stelle sei darauf hingewiesen, dass das Gehäuse 2 bei einer derartigen Ausführungsform eines erfindungsgemäßen Kontaktsystems mit koaxialer Kontaktierung nicht nur aus einem elektrisch isolierenden Material, sondern bevorzugt auch aus einem elektrisch leitenden Material auszuführen sind. Bei einer derartigen Materialauswahl kann über das gesamte Gehäuse 2 ein gemeinsames Massepotential für die einzelnen Kontaktbuchse realisiert werden.

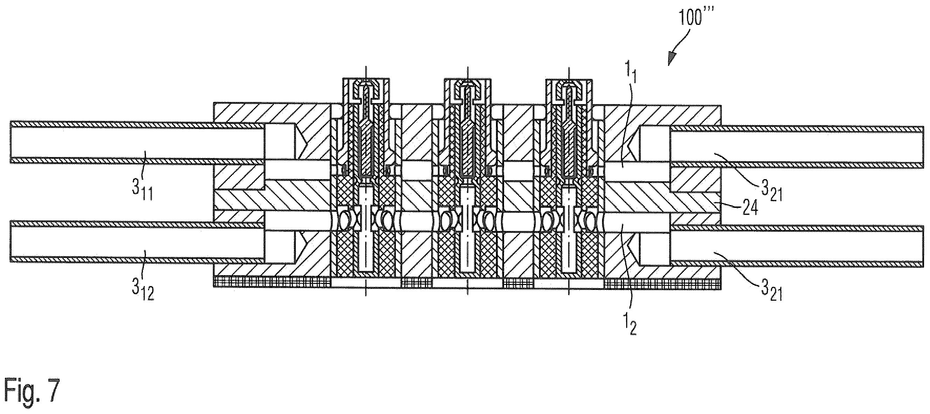

In Fig. 7 ist eine weitere Ausführungsform 100'" eines erfindungsgemäßen Kontaktsystems dargestellt, das für koaxial ausgeführte Kontaktmodule 7'' gemäß der Figuren 4A bis 4C eingesetzt werden kann. Alternativ ist diese weitere Ausführungsform 100"' eines erfindungsgemäßen Kontaktsystems auch für koaxiale Kontaktierung, wie sie in den Figuren 6a bis 6C dargestellt ist, einsetzbar.

Die Druckkammer 1 ist hierbei durch Zwischenschaltung einer weiteren Gehäuseplatte 2₄ in zwei Druckkammern 1₁ und 1₂ aufgeteilt. Die weitere Gehäuseplatte 2₄ weist hierzu für jedes koaxiale Kontaktmodul 7'' jeweils eine geeignet dimensionierte und positionierte Bohrung auf. Jeder Druckkammer 1₁ und 1₂ besitzt jeweils einen separaten ersten und zweiten Zugang 3₁₁ und 3₂₁ bzw. 3₁₂ und 3₂₂ für die Zuführung bzw. Abführung eines Druckmediums auf.

Auf diese Weise lässt sich in jeder Druckkammer 1₁ und 1₂ jeweils ein spezifisches Druckniveau für das Druckmedium einstellen. Somit lassen sich die einzelnen Kontaktstifte mit einem anderen Anpressdruck auf die Kontaktpunkte am Gehäuse der zu prüfenden integrierten Schaltung als die zugehörigen Kontaktbuchsen drücken. Dies ist insbesondere dann erforderlich, wenn die Kontaktstifte aufgrund von starker Oxidationserscheinungen an den zugehörigen Kontaktpunkten einen höheren Anpressdruck zur Auflösung der Oxidationsschichten benötigen.

Obwohl die vorliegende Erfindung anhand bevorzugter Ausführungsbeispiele vorstehend vollständig beschrieben wurde, ist sie nicht darauf beschränkt, sondern auf vielfältige Art und Weise modifizierbar.

### BEZUGSZEICHENLISTE

- 1: Druckkammer
- 2: Gehäuse
- 2₁, 2₂: obere und untere Gehäuseplatte
- 3₁, 3₂: erster und zweiter Zugang
- 4₁, 4₂: Pneumatik-Pumpe
- 5₁, 5₂: Druckregelventil
- 6₁, 6₂, 6₃: erste Durchgangsbohrung
- 6₁', 6₂', 6₃': erste Durchgangsbohrung
- 7, 7₁, 7₂, 7₃: erste Ausführungsform eines Kontaktmoduls
- 7': zweite Ausführungsform eines Kontaktmoduls
- 7": dritte Ausführungsform eines Kontaktmoduls
- 8₁, 8₂, 8₃: zweite Ausführungsform eines Kontaktmoduls
- 9₁, 9₂, 9₃: Signalleitungen
- 10: Leiterplatte
- 11: erste Hülse
- 12, 12₁, 12₂, 12₃: Kontaktstifte
- 13₁, 13₂: erster und zweiter Abschnitt einer ersten Ausführungsform einer ersten Durchführung
- 13₁', 13₂': erster und zweiter Abschnitt einer zweiten Ausführungsform einer ersten Durchführung
- 14₁, 14₂: erster und zweiter Abschnitt eines Kontaktstiftes
- 15: Schulter
- 16: Öffnung
- 17: der Druckkammer zugewandtes Ende des Kontaktstiftes
- 18: Prüfspitze
- 19: Temperaturregler
- 20₁, 20₂, 20₃: erste Luftkanäle
- 21₁, 21₂: zweite Luftkanäle
- 22: erste Bohrung
- 23₁, 23₂, 23₃: zweite Bohrung
- 24: Isolierteil
- 25: erste Ausführungsform einer zweiten Durchführung
- 25': zweite Ausführungsform einer zweiten Durchführung
- 26: zweite Hülse
- 27₁, 27₂: erster und zweiter Abschnitt einer ersten Ausführungsform einer zweiten Durchführung
- 27₁', 27₂': erster und zweiter Abschnitt einer zweiten Ausführungsformeiner zweiten Durchführung
- 28: Kontaktbuchse
- 29₁, 29₂: erster und zweiter Abschnitt der Kontaktbuchse
- 30: Öffnungen
- 31: der Druckkammer zugewandte Ende der Kontaktbuchse
- 32₁, 32₂, 32₃: Durchgänge im Isolatorteil
- 33₁, 33₂: Durchgänge in der zweiten Hülse im Bereich des ersten Abschnitts der zweiten Durchführung
- 34₁, 34₂: Ausnehmungen in den gestuften Durchgangsbohrungen im Bereich des ersten Abschnitts der zweiten Durchführung
- 35: zusätzliche Öffnungen
- 36: von der Prüfspitze entfernte Ende des Kontaktstiftes
- 37: erste Ausführungsform einer ersten Durchführung
- 37': zweite Ausführungsform einer ersten Durchführung
- 38: dritte Hülse
- 200: Gehäuse der integrierten Schaltung
- 201₁, 201₂, 201₃: Kontaktpunkte am Gehäuse der integrierten Schaltung

## Patentansprüche

1. Kontaktsystem (100; 100'; 100'') mit mindestens einem pneumatisch angesteuerten Kontaktstift (12₁, 12₂, 12₃), einer Druckkammer (1), einer in einem Gehäuse (2) der Druckkammer (1) für jeden Kontaktstift (12₁, 12₂, 12₃) jeweils vorgesehenen ersten Durchführung (37; 37'),
wobei jeder Kontaktstift (12₁, 12₂, 12₃) jeweils einen ersten Abschnitt (14₁) mit einem ersten Außendurchmesser und einen an den ersten Abschnitt (14₁) sich anschließenden zweiten Abschnitt (14₂) mit einem gegenüber dem ersten Außendurchmesser größeren zweiten Außendurchmesser aufweist,
wobei jede erste Durchführung (37; 37') einen der Druckkammer (1) abgewandten ersten Abschnitt (13₁; 13₁') mit einem ersten Innendurchmesser und einen der Druckkammer (1) zugewandten zweiten Abschnitt (13₂; 13₂') mit einem gegenüber dem ersten Innendurchmesser größeren zweiten Innendurchmesser aufweist,
wobei der zweite Abschnitt (14₂) jedes Kontaktstiftes (12₁, 12₂, 12₃) im zweiten Abschnitt (13₂; 13₂') der ersten Durchführung (37; 37') axial bewegbar geführt ist und zur Kontaktierung der erste Abschnitt (14₁) des Kontaktstiftes (12₁, 12₂, 12₃) im ersten Abschnitt (13₁; 13₁') der ersten Durchführung (37; 37') durchgeführt ist,
wobei eine bestimmte axiale Position jedes Kontaktstifts (12₁, 12₂, 12₃) in der zugehörigen ersten Durchführung (37; 37') zu einem bestimmten Druckniveau eines Druckmediums in der Druckkammer (1) korrespondiert,
**dadurch gekennzeichnet,**
**dass** das Druckmedium temperaturgeregelt ist.

2. Kontaktsystem (100; 100'; 100'') nach Patentanspruch 1,
**dadurch gekennzeichnet,**
**dass** zwischen dem zweiten Abschnitt (13₂; 13₂') der ersten Durchführung (37; 37') und einem Außenraum der Druckkammer (1) mindestens ein zweiter Luftkanal (21₁, 21₂) vorgesehen ist, der für bestimmte axiale Positionen des Kontaktstiftes (12₁, 12₂, 12₃) in der zugehörigen ersten Durchführung (37; 37') jeweils mit mindestens einem ersten Luftkanal (20₁, 20₂, 20₃) verbunden ist, der jeweils von einem der Druckkammer (1) zugewandten Ende (18) des Kontaktstiftes (12₁, 12₂, 12₃) über eine bestimmte Längserstreckung im zweiten Abschnitt (14₂) des Kontaktstiftes (12₁, 12₂, 12₃) verläuft.

3. Kontaktsystem (100; 100'; 100'') nach Patentanspruch 2,
**dadurch gekennzeichnet,**
**dass** jeder erste Luftkanal (20₁, 20₂, 20₃) jeweils eine in Längsrichtung an einer Zylinderaußenmantelfläche im zweiten Abschnitt (14₂) des Kontaktstiftes (12₁, 12₂, 12₃) verlaufende Ausnehmung ist, die von einer Innenwandung des zweiten Abschnitts (13₂) der ersten Durchführung (37; 37') verschlossen ist.

4. Kontaktsystem (100; 100'; 100'') nach Patentanspruch 3,
**dadurch gekennzeichnet,**
**dass** jede Ausnehmung an ihrem der Druckammer (1) abgewandten Ende jeweils einen konischen oder kegelstumpfförmigen Verlauf aufweist.

5. Kontaktsystem (100; 100'; 100'') nach Patentanspruch 2,
**dadurch gekennzeichnet,**
**dass** jeder erste Luftkanal (20₁, 20₂, 20₃) jeweils eine für jeden ersten Luftkanal (20₁, 20₂, 20₃) gemeinsam in Längsrichtung innerhalb des zweiten Abschnitts (14₂) des Kontaktstiftes (12₁, 12₂, 12₃) verlaufende erste Bohrung (22) und eine sich daran anschließende, in Querrichtung des zweiten Abschnitts (14₂) des Kontaktstiftes (12₁, 12₂, 12₃) verlaufende zweite Bohrung (23₁, 23₂, 23₃) umfasst.

6. Kontaktsystem (100; 100'; 100'') nach einem der Patentansprüche 1 bis 5,
**dadurch gekennzeichnet,**
**dass** jede zu jeweils einem Kontaktstift (12₁, 12₂, 12₃) gehörige erste Durchführung (37; 37') jeweils eine als gestufte Durchgangsbohrung (6₁', 6₂', 6₃') realisierte erste Durchführung (37') im Gehäuse (2) der Druckkammer (1) ist.

7. Kontaktsystem (100; 100'; 100'') nach Patentanspruch 6,
**dadurch gekennzeichnet,**
**dass** ein Teilabschnitt einer ersten Hülse (11') in einem Teilabschnitt des zweiten Abschnitts (13₂') der als gestufte Durchgangsbohrung (6₁', 6₂', 6₃') realisierten ersten Durchführung (37') passgenau fixiert ist und der jeweilige Kontaktstift (12₁, 12₂, 12₃) mit seinem zweiten Abschnitt (14₂) in der zugehörigen ersten Hülse (11') axial bewegbar geführt ist.

8. Kontaktsystem (100; 100'; 100'') nach einem der Patentansprüche 1 bis 5,
**dadurch gekennzeichnet,**
**dass** jede zu jeweils einem Kontaktstift (12₁, 12₂, 12₃) gehörige erste Durchführung (37) jeweils ein Innenraum einer ersten Hülse (11) ist, wobei die erste Hülse (11) passgenau in einer zugehörigen Durchgangsbohrung (6₁, 6₂, 6₃) im Gehäuse (2) der Druckkammer (1) fixiert ist.

9. Kontaktsystem (100; 100'; 100'') nach Patentanspruch 7 oder 8,
**dadurch gekennzeichnet,**
**dass** ein in der Druckkammer (1) befindlicher und vom zugehörigen Kontaktstift (12₁, 12₂, 12₃) vakanter Abschnitt jeder ersten Hülse (11; 11') jeweils mindestens eine Öffnung (16) aufweist.

10. Kontaktsystem (100; 100'; 100'') nach einem der Patentansprüche 7 bis 9,
**dadurch gekennzeichnet,**
**dass** an jeder ersten Hülse (11; 11') oder jedem Kontaktstift (12₁, 12₂, 12₃) jeweils eine Signalleitung (9; 9₁, 9₂, 9₃) befestigt ist.

11. Kontaktsystem (100; 100'; 100'') nach einem der Patentansprüche 7 bis 10,
**dadurch gekennzeichnet,**
**dass** dasjenige Ende jeder ersten Hülse (11; 11), das vom zugehörigen Kontaktstift (12₁, 12₂, 12₃) entfernt ist, jeweils in einer zugehörigen dritten Durchführung (8) im Gehäuse (2) der Druckkammer (1) passgenau fixiert ist.

12. Kontaktsystem (100; 100'; 100'') nach einem der Patentansprüche 1 bis 11,
**dadurch gekennzeichnet,**
**dass** im Gehäuse (2) der Druckkammer (1) konzentrisch zu jeder ersten Durchführung jeweils ein Isolatorteil (24) und eine zweite Durchführung (25; 25') vorgesehen sind, in der eine Kontaktbuchse (28) axial bewegbar ist.

13. Kontaktsystem (100; 100'; 100'') nach einem der Patentansprüche 1 bis 12,
**dadurch gekennzeichnet,**
**dass** die Druckkammer (1) einen ersten Zugang (3₁) zum Aufbau eines ersten Druckniveaus in der Druckkammer (1), insbesondere eines gegenüber dem Druckniveau im Außenraum der Druckkammer (1) höheren Druckniveaus, und einen zweiten Zugang (3₂) zum Aufbau eines zweiten Druckniveaus in der Druckkammer (1), insbesondere eines gegenüber dem Druckniveau im Außenraum der Druckkammer (1) niedrigeren Druckniveaus, aufweist.

14. Kontaktmodul (7; 7'; 7") mit einem pneumatisch ansteuerbaren Kontaktstift (12₁, 12₂, 12₃) und einer ersten Hülse (11), wobei der Kontaktstift (12₁, 12₂, 12₃) jeweils einen ersten Abschnitt (14₁) mit einem ersten Außendurchmesser und einen an den ersten Abschnitt (14₁) sich anschließenden zweiten Abschnitt (14₂) mit einem gegenüber dem ersten Außendurchmesser größeren zweiten Außendurchmesser aufweist, wobei ein Innenraum der ersten Hülse (11) eine erste Durchführung (37) für den Kontaktstift (12₁, 12₂, 12₃) bildet und einen ersten Abschnitt (13₁) mit einem ersten Innendurchmesser und einen zweiten Abschnitt (14₂) mit einem gegenüber dem ersten Innendurchmesser größeren zweiten Innendurchmesser aufweist, wobei der zweite Abschnitt (14₂) des Kontaktstiftes (12₁, 12₂, 12₃) im zweiten Abschnitt (13₂) der ersten Durchführung (37) axial bewegbar geführt ist und zur Kontaktierung der erste Abschnitt (14₁) des Kontaktstiftes (12₁, 12₂, 12₃) im ersten Abschnitt (13₁) der ersten Durchführung (37) durchgeführt ist, wobei eine axiale Position des Kontaktstifts (12₁, 12₂, 12₃) in der ersten Hülse (11) zu einem Druckniveau eines Druckmediums am Ende (18) des zweiten Abschnitts (14₂) des Kontaktstiftes (12₁, 12₂, 12₃) korrespondiert,
**dadurch gekennzeichnet,**
**dass** das Druckmedium temperaturgeregelt ist.

15. Kontaktmodul (7; 7'; 7'') nach Patentanspruch 14,
**dadurch gekennzeichnet,**
**dass** mindestens ein zweiter Luftkanal (21₁, 21₂), der zwischen dem zweiten Abschnitt (13₂) der ersten Durchführung (37) und einem Außenraum der ersten Hülse (11) verläuft, für bestimmte axiale Positionen des Kontaktstiftes (12₁, 12₂, 12₃) in der ersten Hülse (11) mit mindestens einem ersten Luftkanal (20₁, 20₂, 20₃) verbunden ist, der vom Ende (18) des zweiten Abschnitts (13₂) des Kontaktstiftes (12₁, 12₂, 12₃) über eine bestimmte Längserstreckung im zweiten Abschnitt (13₂) des Kontaktstiftes (12₁, 12₂, 12₃) verläuft.

16. Kontaktmodul (7; 7'; 7'') nach Patentanspruch 15,
**dadurch gekennzeichnet,**
**dass** jeder erste Luftkanal (20₁, 20₂, 20₃) jeweils eine in Längsrichtung an einer Zylinderaußenmantelfläche im zweiten Abschnitt (13₂) des Kontaktstiftes (12₁, 12₂, 12₃) verlaufende Ausnehmung ist.

17. Kontaktmodul (7; 7'; 7'') nach Patentanspruch 15,
**dadurch gekennzeichnet,**
**dass** jeder erste Luftkanal (20₁, 20₂, 20₃) jeweils eine für jeden ersten Luftkanal (20₁, 20₂, 20₃) gemeinsam in Längsrichtung des zweiten Abschnitts des Kontaktstiftes verlaufende erste Bohrung (22) und eine sich daran anschließende, in Querrichtung des zweiten Abschnitts (13₂) des Kontaktstiftes (12₁, 12₂, 12₃) verlaufende zweiten Bohrung (23₁, 23₂, 23₃) umfasst.

18. Kontaktmodul (7; 7'; 7'') nach einem der Patentansprüche 14 bis 17,
**dadurch gekennzeichnet,**
**dass** in einem vom Kontaktstift (12₁, 12₂, 12₃) vakanten Teilabschnitt des zweiten Abschnitts (13₁) der ersten Durchführung (37) mindestens eine Öffnung (16) zum Innenraum der ersten Hülse (11) vorgesehen ist.

19. Kontaktmodul (7; 7'; 7'') nach einem der Patentansprüche 14 bis 18,
**dadurch gekennzeichnet,**
**dass** jede Ausnehmung an ihrem der Druckammer (1) abgewandten Ende jeweils einen konischen oder kegelstumpfförmigen Verlauf aufweist.

20. Kontaktmodul (7; 7'; 7'') nach einem der Patentansprüche 14 bis 19,
**dadurch gekennzeichnet,**
**dass** konzentrisch zur ersten Hülse (11) ein Isolatorteil (24) und eine zweite Hülse (26) angeordnet sind, wobei zwischen dem Isolatorteil (24) und der zweiten Hülse (26) eine Kontaktbuchse (28) axial bewegbar ist.

## Claims

1. A contact system (100; 100'; 100") with at least one pneumatically controlled contact pin (12₁, 12₂, 12₃), a pressure chamber (1), a first feedthrough (37; 37') provided in each case in a housing (2) of the pressure chamber (1) for each contact pin (12₁, 12₂, 12₃),
wherein each contact pin (12₁, 12₂, 12₃) in each case has a first section (14₁) with a first outer diameter and a second section (14₂) adjoining the first section (14₁) with a second outer diameter larger than the first outer diameter,
wherein each first feedthrough (37; 37') has a first section (13₁; 13₁') facing away from the pressure chamber (1) with a first inner diameter and a second section (13₂; 13₂') facing the pressure chamber (1) with a second inner diameter larger than the first inner diameter,
wherein the second section (14₂) of each contact pin (12₁, 12₂, 12₃) is guided axially movably in the second section (13₂; 13₂') of the first feedthrough (37; 37') and is passed through in order to contact the first section (14₁) of the contact pin (12₁, 12₂, 12₃) in the first section (13₁; 13₁') of the first feedthrough (37; 37'),
wherein a specific axial position of each contact pin (12₁, 12₂, 12₃) in the associated first feedthrough (37; 37') corresponds to a specific pressure level of a pressure medium in the pressure chamber (1),
**characterized in**
**that** the pressure medium is temperature controlled.

2. A contact system (100; 100'; 100") according to patent claim 1,
**characterized in**
**that** between the second section (13₂; 13₂') of the first feedthrough (37; 37') and an outer area of the pressure chamber (1) at least one second air channel (21₁; 21₂) is provided, which for specific axial positions of the contact pin (12₁, 12₂, 12₃) in the associated first feedthrough (37; 37') is connected in each case with at least one first air channel (20₁, 20₂, 20₃), which in each case extends from an end (18) of the contact pin (12₁, 12₂, 12₃) facing the pressure chamber (1) via a specific longitudinal extent in the second section (14₂) of the contact pin (12₁, 12₂, 12₃).

3. A contact system (100; 100'; 100") according to patent claim 2,
**characterized in**
**that** each first air channel (20₁, 20₂, 20₃) is in each case a recess extending in the longitudinal direction on a cylinder outer lateral surface in the second section (14₂) of the contact pin (12₁, 12₂, 12₃), which recess is closed by an inner wall of the second section (13₂) of the first feedthrough (37; 37').

4. A contact system (100; 100'; 100") according to patent claim 3,
**characterized in**
**that** each recess has in each case a conical or frusto-conical course on its end facing away from the pressure chamber

5. A contact system (100; 100'; 100") according to patent claim 2,
**characterized in**
**that** each first air channel (20₁, 20₂, 20₃) in each case comprises a first borehole (22) for each first air channel (20₁, 20₂, 20₃) running jointly in the longitudinal direction within the second section (14₂) of the contact pin (12₁, 12₂, 12₃) and an adjoining second borehole (23₁, 23₂, 23₃) running in the transverse direction of the second section (14₂) of the contact pin (12₁, 12₂, 12₃).

6. A contact system (100; 100'; 100") according to patent claims 1 to 5,
**characterized in**
**that** each first feedthrough (37; 37') belonging to in each case a contact pin (12₁, 12₂, 12₃) is in each case a first feedthrough (37') realized as stepped through boreholes (6₁', 6₂', 6₃') in the housing (2) of the pressure chamber (1).

7. A contact system (100; 100'; 100") according to patent claim 6,
**characterized in**
**that** a partial-section of a first sleeve (11') is fixed fitted precisely in a partial-section of the second section (13₂') of the first feedthrough (37') realized as a stepped through borehole (6₁', 6₂', 6₃') and the respective contact pin (12₁, 12₂, 12₃) is guided axially movably with its second section (14₂) in the associated first sleeve (11').

8. A contact system (100; 100'; 100") according to patent claims 1 to 5,
**characterized in**
**that** each first feedthrough (37) belonging in each case to a contact pin (12₁, 12₂, 12₃) is in each case an interior of a first sleeve (11), wherein the first sleeve (11) is fixed fitted precisely in an associated through borehole (6₁', 6₂', 6₃') in the housing (2) of the pressure chamber (1).

9. A contact system (100; 100'; 100") according to patent claim 7 or 8,
**characterized in**
**that** a section of each first sleeve (11; 11') located in the pressure chamber (1) and vacant from the associated contact pin (12₁, 12₂, 12₃) has in each case at least one opening (16).

10. A contact system (100; 100'; 100") according to any one of patent claims 7 to 9,
**characterized in**
**that** in each case a signal line (9; 9₁, 9₂, 9₃) is attached to each first sleeve (11; 11') or each contact pin (12₁, 122, 123).

11. A contact system (100; 100'; 100") according to any one of patent claims 7 to 10,
**characterized in**
**that** that end of each first sleeve (11; 11), which is removed from the associated contact pin (12₁, 12₂, 12₃), is in each case fixed fitting precisely in an associated third feedthrough (8) in the housing (2) of the pressure chamber (1).

12. A contact system (100; 100'; 100") according to any one of patent claims 1 to 11,
**characterized in**
**that** in the housing (2) of the pressure chamber (1) in each case an insulator part (24) and a second feedthrough (25; 25') are provided concentrically to each first feedthrough, in which a contact bushing (28) is axially movable.

13. A contact system (100; 100'; 100") according to any one of patent claims 1 to 12,
**characterized in**
**that** the pressure chamber (1) has a first access (3₁) for establishing a first pressure level in the pressure chamber (1), in particular, a pressure level higher than the pressure level in the outer area of the pressure chamber (1), and a second access (3₂) for establishing a second pressure level in the pressure chamber (1), in particular, a pressure level lower than the pressure level in the outer area of the pressure chamber (1).

14. A contact module (7; 7'; 7") with a pneumatically controllable contact pin (12₁, 12₂, 12₃) and a first sleeve (11), wherein the contact pin (12₁, 12₂, 12₃) in each case has a first section (14₁) with a first outer diameter and a second section (14₂) adjoining the first section (14₁) with a second outer diameter larger than the first outer diameter, wherein an interior of the first sleeve (11) forms a first feedthrough (37) for the contact pin (12₁, 12₂, 12₃) and has a first section (13₁) with a first inner diameter and a second section (14₂) with a second inner diameter larger than the first inner diameter, wherein the second section (14₂) of the contact pin (12₁, 12₂, 12₃) is guided axially movably in the second section (13₂) of the first feedthrough (37) and is passed through in order to contact the first section (14₁) of the contact pin (12₁, 12₂, 12₃) in the first section (13₁) of the first feedthrough (37), wherein an axial position of the contact pin (12₁, 12₂, 12₃) corresponds in the first sleeve (11) to a pressure level of a pressure medium at the end (18) of the second section (14₂) of the contact pin (12₁, 12₂, 12₃),
**characterized in**
**that** the pressure medium is temperature controlled.

15. A contact module (7; 7'; 7") according to patent claim 14,
**characterized in**
**that** at least a second air channel (21₁; 21₂), which runs between the second section (13₂) of the first feedthrough (37) and an outer area of the first sleeve (11), for the specific axial position of the contact pin (12₁, 12₂, 12₃) in the first sleeve (11) is connected with at least one first air channel (20₁, 20₂, 20₃), which runs from the end (18) of the second section (13₂) of the contact pin (12₁, 12₂, 12₃) via a specific longitudinal extent in the second section (13₂) in the second section (13₂) of the contact pin (12₁, 12₂, 12₃).

16. A contact module (7; 7'; 7") according to patent claim 15,
**characterized in**
**that** each first air channel (20₁, 20₂, 20₃) is in each case a recess running in the longitudinal direction on a cylinder outer lateral surface in the second section (13₂) of the contact pin (12₁, 12₂, 12₃).

17. A contact module (7; 7'; 7") according to patent claim 15,
**characterized in**
**that** each first air channel (20₁, 20₂, 20₃) comprises in each case a first borehole (22) running for each first air channel (20₁, 20₂, 20₃) jointly in the longitudinal direction of the second section of the contact pin and an adjoining second borehole (23₁, 23₂, 23₃) running in the transverse direction of the second section (13₂) of the contact pin (12₁, 12₂, 12₃).

18. A contact module (7; 7'; 7") according to any one of patent claims 14 to 17,
**characterized in**
**that** in a partial section of the second section (13₁) of the first feedthrough (37) vacant from the contact pin (12₁, 12₂, 12₃) at least one opening (16) is provided for the interior of the first sleeve (11).

19. A contact module (7; 7'; 7") according to any one of patent claims 14 to 18,
**characterized in**
**that** each recess on its end facing away from the pressure chamber (1) in each case has a conical or frusto-conical course.

20. A contact module (7; 7'; 7") according to any one of patent claims 14 to 19,
**characterized in**
**that** an insulator part (24) and a second sleeve (26) are arranged concentrically to the first sleeve (11), wherein between the insulator part (24) and the second sleeve (26) a contact bushing (28) is axially movable.

## Revendications

1. Système de contact (100 ; 100' ; 100") avec au moins une broche de contact (12₁, 12₂, 12₃) d'une chambre de pression (1), un premier passage (37 ; 37') prévu dans un boîtier (2) de la chambre de pression (1) pour chaque broche de contact (12₁, 12₂, 12₃),
chaque broche de contact (12₁, 12₂, 12₃) comprenant une première portion (14₁) avec un premier diamètre extérieur et une deuxième portion (14₂) se raccordant à la première portion (14₁), avec un deuxième diamètre extérieur supérieur au premier diamètre extérieur,
chaque premier passage (37 ; 37') comprenant une première portion (13₁; 13₁') avec un premier diamètre intérieur, opposé à la chambre de pression (1) et une deuxième portion (13₂; 13₂') orientée vers la chambre de pression (1), avec un deuxième diamètre intérieur supérieur au premier diamètre intérieur,
la deuxième portion (14₂) de chaque broche de contact (12₁, 12₂, 12₃) étant guidée de manière mobile axialement dans la deuxième portion (13₂ ; 13₂') du premier passage (37 ; 37') et, pour la mise en contact, la première portion (14₁) de la broche de contact (12₁, 12₂, 12₃) étant guidée dans la première portion (13₁ ; 13₁') du premier passage (37 ; 37'),
une position axiale déterminée de chaque broche de contact (12₁, 12₂, 12₃) dans le premier passage (37 ; 37') concerné correspondant à un niveau de pression déterminé d'un fluide sous pression dans la chambre de pression (1),
**caractérisé en ce que**
le fluide sous pression est régulé en température.

2. Système de contact (100 ; 100' ; 100") selon la revendication 1,
**caractérisé en ce que**
entre la deuxième portion (13₂ ; 13₂') du premier passage (37 ; 37') et un espace extérieur de la chambre de pression (1), est prévu au moins un deuxième canal d'air (21₁, 21₂), qui est relié, pour des positions axiales déterminées de la broche de contact (12₁, 12₂, 12₃) dans le premier passage (37 ; 37') concerné, avec au moins un premier canal d'air (20₁, 20₂, 20₃), qui s'étend à partir d'une extrémité (18) orientée vers la chambre de pression (1) de la broche de contact (12₁, 12₂, 12₃) sur toute l'extension longitudinale déterminée dans la deuxième portion (14₂) de la broche de contact (12₁, 12₂, 12₃) .

3. Système de contact (100 ; 100' ; 100") selon la revendication 2,
**caractérisé en ce que**
chaque premier canal d'air (20₁, 20₂, 20₃), est un évidement s'étendant dans la direction longitudinale sur une surface d'enveloppe externe de cylindre dans la deuxième portion (14₂) de la broche de contact (12₁, 12₂, 12₃), qui est fermée par une paroi interne de la deuxième portion (13₂) du premier passage (37 ; 37').

4. Système de contact (100 ; 100' ; 100") selon la revendication 3,
**caractérisé en ce que**
chaque évidement présente, au niveau de son extrémité opposée à la chambre de pression (1), une extension conique ou de forme tronconique.

5. Système de contact (100 ; 100' ; 100") selon la revendication 2,
**caractérisé en ce que**
chaque premier canal d'air (20₁, 20₂, 20₃) comprend un premier alésage (22) s'étendant, pour chaque premier canal d'air (20₁, 20₂, 20₃) conjointement dans la direction longitudinale à l'intérieur de la deuxième portion (14₂) de la broche de contact (12₁, 12₂, 12₃) et un deuxième alésage (23₁, 23₂, 23₃) se raccordant à celui-ci et s'étendant dans la direction transversale de la deuxième portion (14₂) de la broche de contact (12₁, 12₂, 12₃).

6. Système de contact (100 ; 100' ; 100") selon l'une des revendications 1 à 5,
**caractérisé en ce que**
chaque premier passage (37 ; 37') appartenant à une broche de contact (12₁, 12₂, 12₃) est un premier passage (37') dans le boîtier (2) de la chambre de pression (1), réalisé comme un alésage de passage échelonné (6₁', 6₂', 6₃').

7. Système de contact (100 ; 100' ; 100") selon la revendication 6,
**caractérisé en ce que**
une partie d'un premier manchon (11') est fixée de manière ajustée dans une partie de la deuxième portion (13₂') du premier passage (37') réalisé comme un alésage de passage échelonné (6₁', 6₂', 6₃') et la broche de contact (12₁, 12₂, 12₃) concernée est guidée de manière mobile axialement avec sa deuxième portion (14₂) dans le premier manchon (11') correspondant.

8. Système de contact (100 ; 100' ; 100") selon l'une des revendications 1 à 5,
**caractérisé en ce que**
chaque premier passage (37) appartenant à une broche de contact (12₁, 12₂, 12₃) est un espace intérieur d'un premier manchon (11), le premier manchon (11) étant fixé de manière ajustée dans un alésage de passage (6₁, 6₂, 6₃) correspondant dans le boîtier (2) de la chambre de pression (1).

9. Système de contact (100 ; 100' ; 100") selon la revendication 7 ou 8,
**caractérisé en ce que**
chaque portion, se trouvant dans la chambre de pression (1) et vacante de la broche de contact (12₁, 12₂, 12₃) correspondante de chaque premier manchon (11 ; 11') comprend au moins une ouverture (16).

10. Système de contact (100 ; 100' ; 100") selon l'une des revendications 7 à 9,
**caractérisé en ce que**
à chaque premier manchon (11 ; 11') ou à chaque broche de contact (12₁, 12₂, 123) est fixée une ligne de signaux (9 ; 9₁, 92, 93).

11. Système de contact (100 ; 100' ; 100") selon l'une des revendications 7 à 10,
**caractérisé en ce que**
l'extrémité de chaque premier manchon (11 ; 11), qui est éloignée de la broche de contact (12₁, 12₂, 12₃) concernée, est fixée de manière ajustée dans un troisième passage (8) correspondant dans le boîtier (2) de la chambre de pression (1).

12. Système de contact (100 ; 100' ; 100") selon l'une des revendications 1 à 11,
**caractérisé en ce que**
dans le boîtier (2) de la chambre de pression (1), sont prévus, de manière concentrique par rapport au premier passage, une partie isolante (24) et un deuxième passage (25 ; 25'), dans lequel une douille de contact (28) est mobile axialement.

13. Système de contact (100 ; 100' ; 100") selon l'une des revendications 1 à 12,
**caractérisé en ce que**
la chambre de pression (1) comprend un premier accès (3₁) pour l'établissement d'un premier niveau de pression dans la chambre de pression (1), plus particulièrement d'un niveau de pression supérieur au niveau de pression dans l'espace extérieur de la chambre de pression (1), et un deuxième accès (3₂) pour l'établissement d'un deuxième niveau de pression dans la chambre de pression (1), plus particulièrement d'un niveau de pression inférieur au niveau de pression dans l'espace extérieur de la chambre de pression (1).

14. Module de contact (7 ; 7' ; 7") avec une broche de contact (12₁, 12₂, 12₃) pouvant être contrôlée de manière pneumatique et un premier manchon (11), la broche de contact (12₁, 12₂, 12₃) comprenant une première portion (14₁) avec un premier diamètre extérieur et une deuxième portion (14₂) se raccordant à la première portion (14₁), avec un deuxième diamètre extérieur supérieur au premier diamètre extérieur, un espace extérieur du premier manchon (11) formant un premier passage (37) pour la broche de contact (12₁, 12₂, 12₃) et une première portion (13₁) avec un premier diamètre intérieur et une deuxième portion (14₂) avec un deuxième diamètre intérieur supérieur au premier diamètre intérieur, la deuxième portion (14₂) de la broche de contact (12₁, 12₂, 12₃) étant guidée de manière mobile axialement dans la deuxième portion (13₂) du premier passage (37) et, pour la mise en contact, la première portion (14₁) de la broche de contact (12₁, 12₂, 12₃), est passée dans la première portion (13₁) du premier passage (37), une position axiale de la broche de contact (12₁, 12₂, 12₃), dans le premier manchon (11) à un niveau de pression d'un fluide sous pression à l'extrémité de la deuxième portion (14₂) de la broche de contact (12₁, 12₂, 12₃),
**caractérisé en ce que**
le fluide sous pression est régulé en température.

15. Module contact (7 ; 7' ; 7") selon la revendication 14,
**caractérisé en ce que**
au moins un deuxième canal d'air (21₁, 21₂), qui s'étend entre la deuxième portion (13₂) du premier passage (37) et un espace extérieur du premier manchon (11) relié, pour des positions axiales déterminées de la broche de contact (12₁, 12₂, 12₃) dans le premier manchon (11), avec au moins un premier canal d'air (20₁, 20₂, 20₃), qui s'étend à partir de l'extrémité (18) de la deuxième portion (13₂) de la broche de contact (12₁, 12₂, 12₃) sur une extension longitudinale déterminée dans la deuxième portion (13₂) de la broche de contact (12₁, 12₂, 12₃).

16. Module contact (7 ; 7' ; 7") selon la revendication 15,
**caractérisé en ce que**
chaque premier canal d'air (20₁, 20₂, 20₃) est un évidement s'étendant dans la direction longitudinale sur une surface d'enveloppe externe cylindrique dans la deuxième portion (13₂) de la broche de contact (12₁, 12₂, 12₃).

17. Module contact (7 ; 7' ; 7") selon la revendication 15,
**caractérisé en ce que**
chaque premier canal d'air (20₁, 20₂, 20₃) comprend un premier alésage (22) s'étendant, pour chaque premier canal d'air (20₁, 20₂, 20₃) conjointement dans la direction longitudinale de la deuxième portion de la broche de contact et un deuxième alésage (23₁, 23₂, 23₃) se raccordant à celui-ci et s'étendant dans la direction transversale de la deuxième portion (13₂) de la broche de contact (12₁, 12₂, 12₃).

18. Module contact (7 ; 7' ; 7") selon l'une des revendications 14 à 17,
**caractérisé en ce que**
dans une partie de la deuxième portion (13₁) du premier passage (37), vacante de la broche de contact (12₁, 12₂, 12₃), est prévu au moins une ouverture (16) vers l'espace intérieur du premier manchon (11).

19. Module contact (7 ; 7' ; 7") selon l'une des revendications 14 à 18,
**caractérisé en ce que**
chaque évidement présente, au niveau de son extrémité opposée à la chambre de pression (1), une forme conique ou tronconique.

20. Module contact (7 ; 7' ; 7") selon l'une des revendications 14 à 19,
**caractérisé en ce que**
de manière concentrique par rapport au premier manchon (11), sont disposés une partie isolante (24) et un deuxième manchon (26), moyennant quoi, entre la partie isolante (24) et le deuxième manchon (26), une douille de contact (28) est mobile axialement.
